# EUROPEAN PATENT APPLICATION

(11) **EP 4 529 381 A1**
(43) Date of publication of application: **26.03.2025**
(21) Application number: 24196872.6
(22) Date of filing: 28.08.2024
(51) Int. Cl.: H10B 12/00

(54) **SEMICONDUCTOR DEVICES INCLUDING BIT LINES**

(30) Priority: 25.09.2023 KR 20230128483
(71) Applicant: Samsung Electronics Co., Ltd., Gyeonggi-do, 16677 (KR)
(72) Inventor: OH, Seran, 16677 Suwon-si, Gyeonggi-do (KR); KANG, Yunho, 16677 Suwon-si, Gyeonggi-do (KR); KIM, Minsik, 16677 Suwon-si, Gyeonggi-do (KR); KIM, Yeonuk, 16677 Suwon-si, Gyeonggi-do (KR); LEE, Byounghoon, 16677 Suwon-si, Gyeonggi-do (KR); LEE, Jangeun, 16677 Suwon-si, Gyeonggi-do (KR)
(74) Representative: Kuhnen & Wacker Patent- und Rechtsanwaltsbüro PartG mbB

(57) **Abstract**

A semiconductor device (100) may include a substrate (110) including a first active region (AC1) defined by a first device isolation layer (112), a bit line contact (DC) arranged on the first active region (AC1) of the substrate (110), and a bit line (BL) that extends in a first direction (Y) on the substrate (110). The bit line (BL) includes a lower conductive layer (132) arranged on the substrate (110) and on a sidewall of the bit line contact (DC) and a metal line stack (136) arranged on the lower conductive layer (132). The metal line stack (136) includes a first conductive layer (136A) arranged on the lower conductive layer (132) and the bit line contact (DC) and including a first metal material, a first intermediate layer (138A) arranged on the first conductive layer (136A) and including graphene, and a second conductive layer (136B) arranged on the first intermediate layer (138A) and including the first metal material.

## Description

### BACKGROUND

The present disclosure relates to semiconductor devices, and more particularly, to semiconductor devices including bit lines.

As semiconductor devices are downscaled, the sizes of individual microcircuit patterns for implementing semiconductor devices are further reduced. In addition, as integrated circuit devices become more highly integrated, line widths of bit lines may decrease and a spacing between the bit lines (or pitch) may decrease. Therefore, a problem is that defects may occur in formation processes of bit lines with reduced line widths.

### SUMMARY

The present disclosure relates to semiconductor devices and methods of forming thereof in which defects are reduced or prevented from occurring in formation processes of bit lines with reduced line widths.

According to some aspects of the inventive concepts, there is provided a semiconductor device including a substrate including a first active region defined by a first device isolation layer, a bit line contact arranged on the first active region of the substrate, and a bit line that extends in a first direction on the substrate. The bit line includes a lower conductive layer arranged on the substrate and on a sidewall of the bit line contact and a metal line stack arranged on the lower conductive layer. The metal line stack includes a first conductive layer arranged on the lower conductive layer and the bit line contact and including a first metal material, a first intermediate layer arranged on the first conductive layer and including graphene, and a second conductive layer arranged on the first intermediate layer and including the first metal material.

According to some aspects of the inventive concepts, there is provided a semiconductor device including a substrate including a first active region defined by a first device isolation layer and a second active region defined by a second device isolation layer, a bit line contact arranged on the first active region of the substrate, a bit line that extends in a first direction on the substrate, and a peripheral circuit gate stack arranged on the second active region. The bit line includes a lower conductive layer arranged on the substrate and on a sidewall of the bit line contact and a metal line stack arranged on the lower conductive layer. The metal line stack includes a first conductive layer arranged on the lower conductive layer and the bit line contact and including a first metal material, a first intermediate layer arranged on the first conductive layer and including graphene, and a second conductive layer arranged on the first intermediate layer and including the first metal material.

According to some aspects of the inventive concepts, there is provided a semiconductor device including a substrate including a first active region defined by a first device isolation layer, a bit line contact that is arranged in a bit line contact hole that extends to the substrate, the bit line contact connected to the first active region of the substrate, and, a bit line extending in a first direction on the substrate, a lower conductive layer that is arranged on the substrate, on a sidewall of the bit line contact, and that extends in the first direction, a metal silicide layer that is arranged on the lower conductive layer and that extends in the first direction, a bit line including a metal line stack that is arranged on the metal silicide layer, that extends in the first direction, including a first conductive layer, a second conductive layer, and a first intermediate layer, wherein the first conductive layer includes a first metal material, the second conductive layer includes the first metal material, and the first intermediate layer is between the first conductive layer and the second conductive layer, and includes graphene. The semiconductor device includes a bit line spacer that is arranged on sidewalls of the bit line and that extends in the first direction, and a word line that is arranged in a word line trench that extends in a second direction that intersects with the first direction, the word line trench intersecting the first active region in the substrate.

### BRIEF DESCRIPTION OF THE DRAWINGS

Embodiments will be more clearly understood from the following detailed description taken in conjunction with the accompanying drawings in which:
FIG. 1 is a layout diagram illustrating a semiconductor device according to some embodiments;
FIG. 2 is an enlarged layout diagram of a portion II of FIG. 1;
FIG. 3 is a cross-sectional view taken along the line A-A' of FIG. 2;
FIG. 4 is a cross-sectional view taken along the line B-B' of FIG. 2;
FIG. 5 is a cross-sectional view taken along the line C-C' of FIG. 2;
FIG. 6 is an enlarged view of a portion CX1 of FIG. 3;
FIGS. 7 and 8 are cross-sectional views illustrating semiconductor devices according to some embodiments;
FIGS. 9 and 10 are cross-sectional views illustrating semiconductor devices according to some embodiments;
FIGS. 11 and 12 are cross-sectional views illustrating semiconductor devices according to some embodiments;
FIGS. 13A, 13B, 14A, 14B, 15A, 15B, 16A, 16B, 17A, 17B, 18A, 18B, 19A, 19B, 20A, 20B, 21A, 21B, 22A, and 22B are cross-sectional views illustrating a method of manufacturing a semiconductor device, according to some embodiments;
FIG. 23 is a graph illustrating X-ray photoelectron spectroscopy measurement results of a metal line stack according to some embodiments;
FIG. 24 is a graph illustrating a Raman spectrum of a metal line stack according to some embodiments;
FIG. 25 is a graph illustrating a change in roughness of a metal line according to a comparative example and a metal line stack according to some embodiments before and after annealing; and
FIG. 26 is a graph illustrating a change in resistivity of a metal line according to a comparative example and a metal line stack according to some embodiments before and after annealing.

### DETAILED DESCRIPTION

Hereinafter, some examples of embodiments of the inventive concepts will be described in detail with reference to the accompanying drawings.

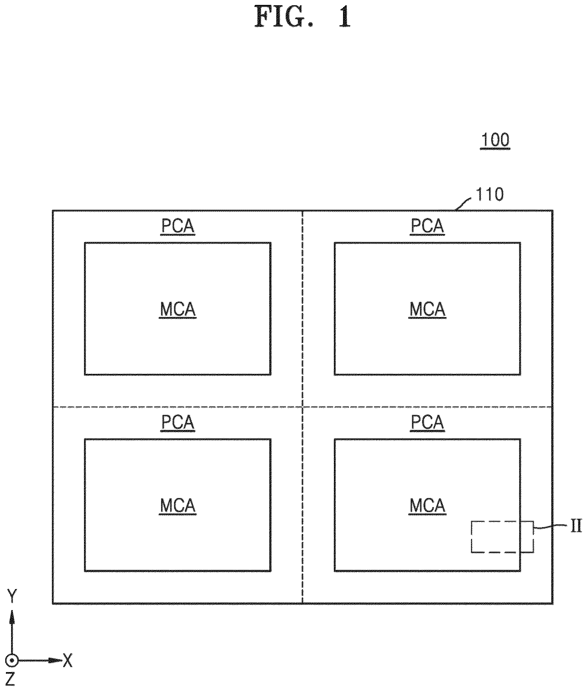

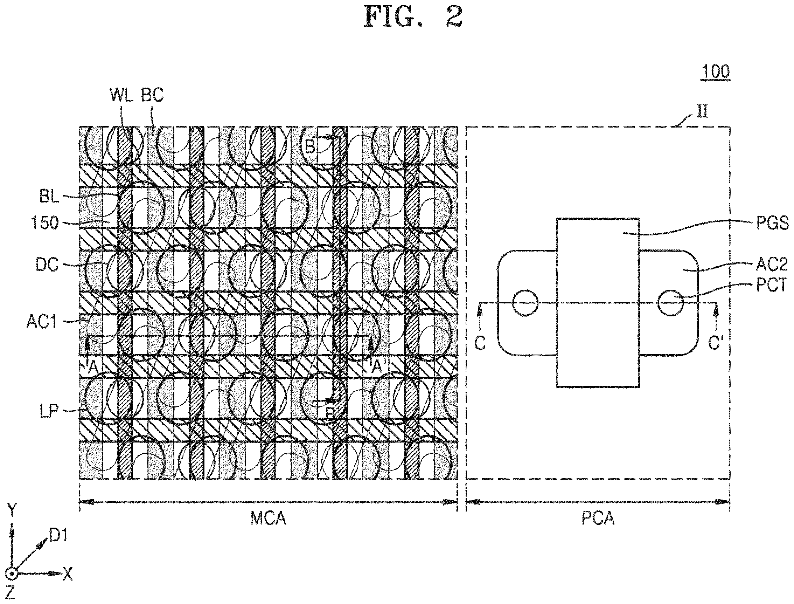

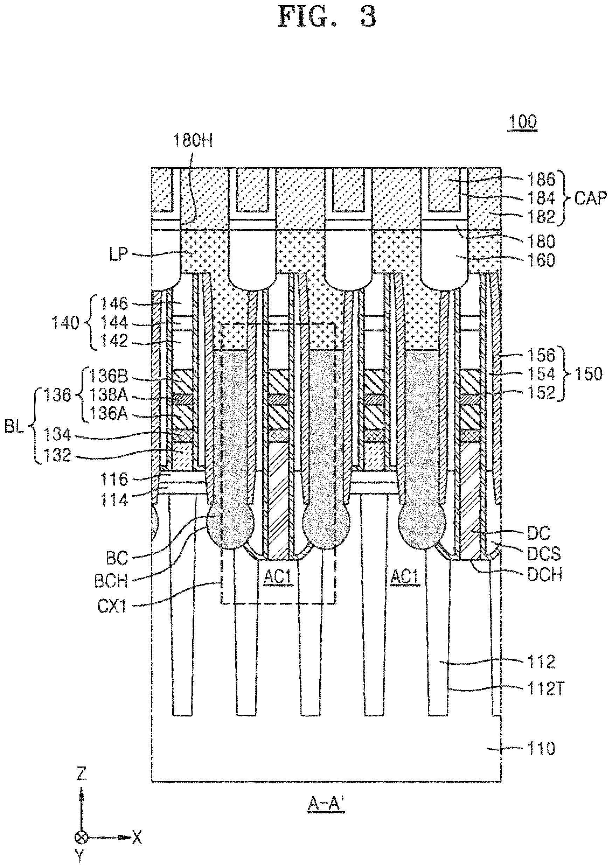

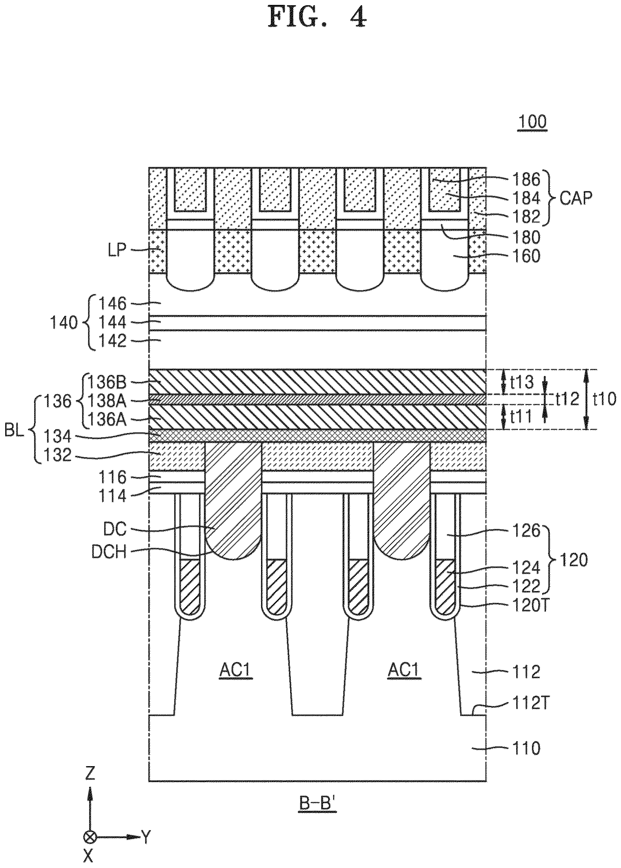

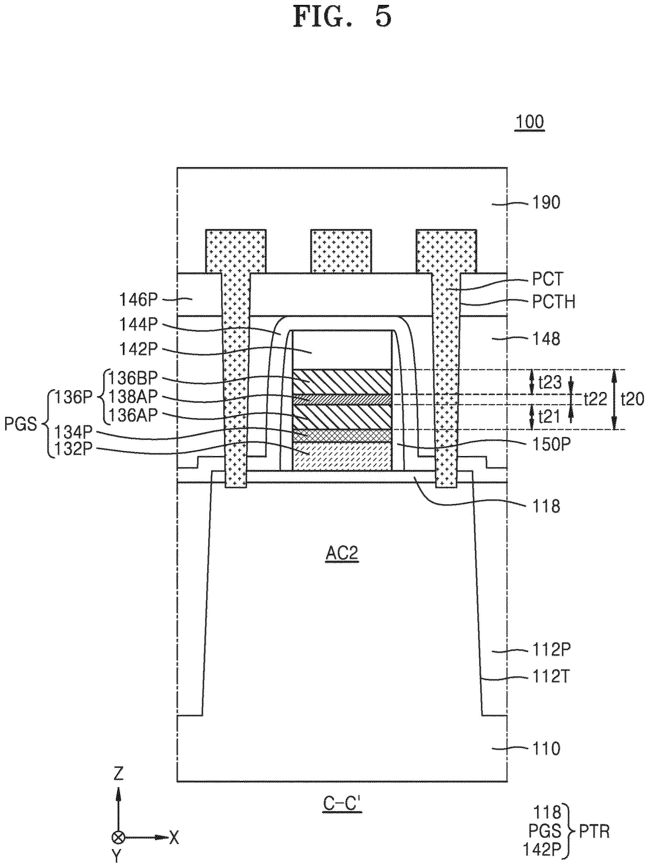

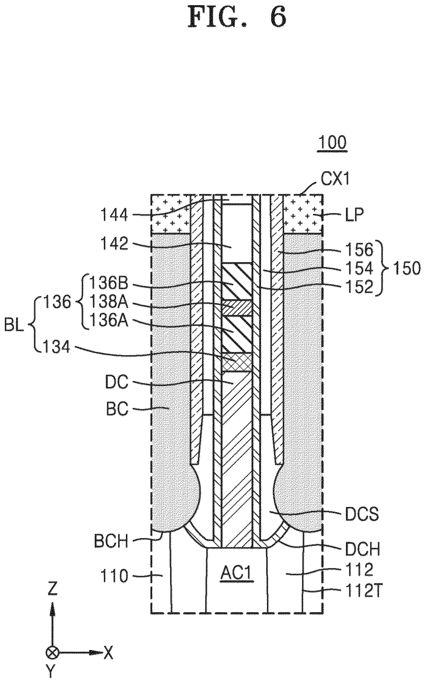

FIG. 1 is a layout diagram illustrating a semiconductor device 100 according to some embodiments. FIG. 2 is an enlarged layout diagram of a portion II of FIG. 1. FIG. 3 is a cross-sectional view taken along the line A-A' of FIG. 2. FIG. 4 is a cross-sectional view taken along the line B-B' of FIG. 2. FIG. 5 is a cross-sectional view taken along the line C-C' of FIG. 2. FIG. 6 is an enlarged view of a portion CX1 of FIG. 3.

Referring to FIGS. 1 to 6, the semiconductor device 100 may include a substrate 110 including a cell array region MCA and a peripheral circuit region PCA. The cell array region MCA may include a memory cell region of a dynamic random access memory (DRAM) device, and the peripheral circuit region PCA may include a core region or a peripheral circuit region of the DRAM device. For example, the cell array region MCA may include a cell transistor and a capacitor structure CAP connected thereto, and the peripheral circuit region PCA may include a peripheral circuit transistor PTR configured to transmit signals and/or power to the cell transistor included in the cell array region MCA. In some embodiments, the peripheral circuit transistor PTR may constitute various circuits, such as a command decoder, control logic, an address buffer, a row decoder, a column decoder, a sense amplifier, and/or a data input/output circuit.

A device isolation trench 112T may be formed in the substrate 110, and a first device isolation layer 112 and a second device isolation layer 112P may be formed in the device isolation trench 112T. A plurality of first active regions AC1 may be defined in the cell array region MCA of the substrate 110 by the first device isolation layer 112, and a plurality of second active regions AC2 may be defined in the peripheral circuit region PCA by the second device isolation layer 112P.

As illustrated in FIG. 2, in the cell array region MCA, each of the plurality of first active regions AC1 may be arranged to have a longitudinal axis in a first diagonal direction D1 inclined or angled with respect to a first horizontal direction X and a second horizontal direction Y. A plurality of word lines WL may extend in parallel to one another in the first horizontal direction X across the plurality of first active regions AC1. On the plurality of word lines WL, a plurality of bit lines BL may extend in parallel to one another in the second horizontal direction Y. Each of the plurality of bit lines BL may be connected to the plurality of first active regions AC1 through a plurality of bit line contacts DC.

A plurality of buried contacts BC may each be formed between each two adjacent bit lines BL among the plurality of bit lines BL. A plurality of landing pads LP may be respectively formed on the plurality of buried contacts BC. The plurality of buried contacts BC and the plurality of landing pads LP may connect lower electrodes 182 of a plurality of capacitor structures CAP formed on the plurality of bit lines BL to the plurality of first active regions AC1. The plurality of landing pads LP may partially overlap the plurality of buried contacts BC and the plurality of bit lines BL, respectively.

The substrate 110 may include silicon (Si), for example, single crystalline Si, polycrystalline Si, or amorphous Si. In some embodiments, the substrate 110 may include at least one selected from germanium (Ge), silicon germanium (SiGe), silicon carbide (SiC), gallium arsenide (GaAs), indium arsenide (InAs), and indium phosphide (InP). In some embodiments, the substrate 110 may include a conductive region, for example, a well doped with impurities or a structure doped with impurities.

The first device isolation layer 112 may include an oxide layer, a nitride layer, or a combination thereof. A first buffer insulating layer 114 and a second buffer insulating layer 116 may be sequentially arranged on a top surface of the substrate 110. Each of the first buffer insulating layer 114 and the second buffer insulating layer 116 may include silicon oxide, silicon oxynitride, or silicon nitride.

A plurality of word line trenches 120T may extend in the first horizontal direction X and may be arranged in the substrate 110, and a buried gate structure 120 may be arranged in the plurality of word line trenches 120T. The buried gate structure 120 may include a gate dielectric layer 122, a gate electrode 124, and a word line capping layer 126 arranged in each of the plurality of word line trenches 120T. The plurality of gate electrodes 124 may correspond to the plurality of word lines WL illustrated in FIG. 2.

The plurality of gate dielectric layers 122 may include a silicon oxide layer, a silicon nitride layer, a silicon oxynitride layer, an oxide/nitride/oxide (ONO) layer, or a high-k dielectric layer having a higher dielectric constant than the silicon oxide layer. The plurality of gate electrodes 124 may include titanium (Ti), titanium nitride (TiN), tantalum (Ta), tantalum nitride (TaN), tungsten (W), tungsten nitride (WN), titanium silicon nitride (TiSiN), tungsten silicon nitride (WSiN), or a combination of thereof. The plurality of word line capping layers 126 may include a silicon oxide layer, a silicon nitride layer, a silicon oxynitride layer, or a combination thereof.

A plurality of bit line contact holes DCH may extend into the substrate 110 through the first buffer insulating layer 114 and the second buffer insulating layer 116, and the plurality of bit line contacts DC may be formed in the plurality of bit line contact holes DCH. The plurality of bit line contacts DC may be connected to the plurality of first active regions AC1, respectively. The plurality of bit line contacts DC may include TiN, TiSiN, W, tungsten silicide, doped polysilicon, or a combination of thereof. A plurality of bit line contact spacers DCS may cover lower sides of the plurality of bit line contacts DC in the plurality of bit line contact holes DCH, respectively.

The plurality of bit lines BL may extend in length in the second horizontal direction Y on the substrate 110 and the plurality of bit line contacts DC. The plurality of bit lines BL may be connected to the plurality of first active regions AC1 through the plurality of bit line contacts DC, respectively.

Each of the plurality of bit lines BL may include a lower conductive layer 132, a metal silicide layer 134, and a metal line stack 136.

The lower conductive layer 132 may extend in the second horizontal direction Y on the second buffer insulating layer 116 and may cover both sidewalls of the bit line contact DC. For example, as illustrated in FIG. 3, a top surface of the lower conductive layer 132 may be coplanar with a top surface of the bit line contact DC and the both sidewalls of the bit line contact DC may contact the lower conductive layer 132. The lower conductive layer 132 may include Si, Ge, W, WN, cobalt (Co), nickel (Ni), aluminum (Al), molybdenum (Mo), ruthenium (Ru), Ti, TiN, Ta, TaN, or copper (Cu), or a combination of two or more thereof.

In some embodiments, in a process of forming the bit line contact hole DCH, a part of the lower conductive layer 132, a part of the second buffer insulating layer 116, a part of the first buffer insulating layer 114, and a part of the substrate 110 may be removed, and the bit line contact DC may be formed in the bit line contact hole DCH. Accordingly, an upper side of the bit line contact DC may contact the lower conductive layer 132, and a lower side of the bit line contact DC may contact the substrate 110 (for example, the first active region AC1).

The metal silicide layer 134 may be arranged on the top surface of the lower conductive layer 132 and on the top surface of the bit line contact DC to extend in the second horizontal direction Y. In some embodiments, the lower conductive layer 132 may include polysilicon, and the metal silicide layer 134 may include at least one of cobalt silicide, nickel silicide, and tungsten silicide. In some embodiments, optionally, at least one conductive barrier layer of Ti, TiN, and TaN may be further arranged on the metal silicide layer 134.

The metal line stack 136 may include a first conductive layer 136A, a first intermediate layer 138A, and a second conductive layer 136B sequentially arranged on the metal silicide layer 134. For example, the metal line stack 136 may have a structure in which the first intermediate layer 138A is sandwiched between the first conductive layer 136A and the second conductive layer 136B.

In some embodiments, the first conductive layer 136A may include a first metal material, and the first metal material may include any one of Ru, Mo, rhodium (Ro), iridium (Ir), and an alloy thereof. In some embodiments, the first conductive layer 136A may include Ru.

In some embodiments, the first intermediate layer 138A may include graphene. In embodiments, graphene constituting the first intermediate layer 138A may include a plurality of grains having a two-dimensional structure. For example, each grain of the first intermediate layer 138A may have a two-dimensional structure in which 1 to 15 layers of carbon two-dimensional sheets are stacked layer-by-layer. In some embodiments, the first intermediate layer 138A may have a nanocrystalline structure and a plurality of grains may have a grain size of about 2 nm to about 200 nm. In some embodiments, the first intermediate layer 138A may have an average grain size of 10 nm or more.

In some embodiments, in terms of bonding energy of carbon atoms included in graphene, the first intermediate layer 138A may include graphene including carbon atoms having sp² bonding in a ratio of 50% or more and 99% or less of all carbon atoms. The binding energy of the carbon atoms included in the first intermediate layer 138A may be measured by using an analysis device such as X-ray photoelectron spectroscopy (XPS).

In some embodiments, the first intermediate layer 138A may exhibit a D peak, a 2D peak, a D' peak, and a G peak of carbon atoms when measured by Raman spectroscopy, and a ratio of the D peak to the G peak of carbon atoms may be 3.0 or less, a ratio of the 2D peak to the G peak may be 0.1 or more, and a ratio of a D' peak to the G peak may be 1.0 or less. Here, the G peak may correspond to a Raman shift value of about 1,580 cm⁻¹, the D peak may correspond to a Raman shift value of about 1,350 cm⁻¹, and the 2D peak may correspond to a Raman shift value of about 2,700 cm⁻¹.

In some embodiments, the second conductive layer 136B may include a first metal material, and the first metal material may include any one of Ru, Mo, rhodium (Ro), iridium (Ir), and/or an alloy thereof. In some embodiments, the second conductive layer 136B may include Ru.

In some embodiments, the first intermediate layer 138A may be between the first conductive layer 136A and the second conductive layer 136B and may function as an anti-agglomeration layer that suppresses grain agglomeration or grain merging of the first metal material included in the first conductive layer 136A and the second conductive layer 136B.

For example, in the case of a bit line BL including a single layer of a metal material such as Ru according to a comparative example, when the bit line BL has a reduced line width (for example, a relatively small line width, such as a line width less than 10 nm), the metal material such as Ru included in the bit line BL may cause grain agglomeration or grain merging in a high-temperature subsequent process. The bit line BL according to the comparative example is formed as a line pattern extending in the second horizontal direction Y, but after undergoing a high-temperature subsequent process, a line width of a part of the bit line BL may locally increase due to grain agglomeration such that a line width of another part of the bit line BL may locally decrease or a region in which the bit line BL is discontinuously disconnected may be formed.

However, in some embodiments according to the present disclosure, the first intermediate layer 138A may be between the first conductive layer 136A and the second conductive layer 136B to function as the anti-agglomeration layer that suppresses grain agglomeration or grain merging of the first metal material included in the first conductive layer 136A and the second conductive layer 136B. Accordingly, although the bit line BL has a reduced line width (for example, a relatively small line width), it is possible to prevent grain agglomeration of the first metal material included in the first conductive layer 136A and the second conductive layer 136B.

In embodiments, the metal line stack 136 may have a first thickness t10 in a vertical direction Z. The first conductive layer 136A may have a second thickness t11 in the vertical direction Z, the first intermediate layer 138A may have a third thickness t12 in the vertical direction Z, and the second conductive layer 136B may have a fourth thickness t13 in the vertical direction Z. The second thickness 111 of the first conductive layer 136A may correspond to about 20% to about 80% of the first thickness t10 of the metal line stack 136 in the vertical direction Z. The fourth thickness t13 of the second conductive layer 136B may correspond to about 20% to about 80% of the first thickness t10 of the metal line stack 136 in the vertical direction Z.

The third thickness t12 of the first intermediate layer 138A may correspond to about 5% to about 50% of the first thickness t10 of the metal line stack 136 in the vertical direction Z. For example, when the third thickness t12 of the first intermediate layer 138A is less than 5% of the first thickness t10 of the metal line stack 136, the first intermediate layer 138A may not be thick enough to perform a grain agglomeration suppression function, and when the third thickness t12 of the first intermediate layer 138A is greater than 50% of the first thickness 110, resistivity of the entirety of the metal line stack 136 may increase so that electrical performance of the semiconductor device 100 may deteriorate. In some embodiments, the third thickness t12 of the first intermediate layer 138A may be 5 nm or less. In some embodiments, the third thickness t12 of the first intermediate layer 138A may be 0.5 nm or more.

A plurality of bit line capping layers 140 may be arranged on the plurality of bit lines BL, respectively. Each of the plurality of bit line capping layers 140 may include a first capping layer 142, a second capping layer 144, and a third capping layer 146 that are sequentially arranged on a top surface of each of the plurality of bit lines BL. The first capping layer 142, the second capping layer 144, and the third capping layer 146 may include at least one of silicon nitride, silicon oxide, and/or silicon oxynitride.

A bit line spacer 150 may be arranged on both sidewalls of each of the plurality of bit lines BL. The bit line spacer 150 may include a first spacer layer 152, a second spacer layer 154, and a third spacer layer 156. In some embodiments, the first spacer layer 152 and the third spacer layer 156 may include silicon nitride, and the second spacer layer 154 may include silicon oxide. The first spacer layer 152, the second spacer layer 154, and the third spacer layer 156 may be sequentially arranged on the sidewalls of the bit line BL and sidewalls of the bit line capping layer 140.

For example, as the bit line spacer 150 is arranged on the sidewalls of the bit line BL, the first spacer layer 152 of the bit line spacer 150 may contact the metal line stack 136 of the bit line BL, and for example, the first spacer layer 152 may extend in the vertical direction Z along the sidewalls of the first conductive layer 136A, the first intermediate layer 138A, and the second conductive layer 136B of the metal line stack 136.

A plurality of buried contacts BC may each be arranged between each two adjacent bit lines BL among the plurality of bit lines BL. For example, a bottom of each of the plurality of buried contacts BC may be arranged in the buried contact hole BCH extending into the substrate 110 between two adjacent bit lines BL and may contact the first active region AC1. In embodiments, the plurality of buried contacts BC may include doped polysilicon.

A plurality of insulating fences (not shown) may be arranged between two adjacent bit lines BL in the second horizontal direction Y. The plurality of insulating fences may be arranged at positions vertically overlapping a plurality of word line trenches 120T. In a plan view, each of the plurality of buried contacts BC and each of the plurality of insulating fences may be alternately arranged between two bit lines BL extending in the second horizontal direction Y.

The plurality of landing pads LP may be arranged on the plurality of buried contacts BC, respectively. Each of the plurality of landing pads LP may include a conductive barrier layer (not shown) and a landing pad conductive layer (not shown). The conductive barrier layer may include Ti or TiN, or a combination thereof. The landing pad conductive layer may include metal, metal nitride, or conductive polysilicon, or a combination of two or more thereof. For example, the landing pad conductive layer may include W. The plurality of landing pads LP may have a plurality of island pattern shapes in a plan view.

The plurality of landing pads LP may be electrically insulated from one another by insulating patterns 160 surrounding the plurality of landing pads LP. The insulating patterns 160 may include at least one of silicon nitride, silicon oxide, and silicon oxynitride.

Etching stop layers 180 may be arranged on the insulating patterns 160, and the etching stop layers 180 may include openings 180H, respectively. The openings 180H may be arranged at positions corresponding to the plurality of landing pads LP, and top surfaces of the plurality of landing pads LP may be arranged on bottoms of the openings 180H.

A capacitor structure CAP may be arranged on each of the etching stop layers 180. The capacitor structure CAP may include a lower electrode 182, a capacitor dielectric layer 184, and an upper electrode 186. A bottom of the lower electrode 182 may be arranged in the opening 180H of the etching stop layer 180 so that the bottom of the lower electrode 182 is provided on the landing pad LP. The capacitor dielectric layer 184 may be arranged to be relatively thin so as to cover and conform to the lower electrode 182, and the upper electrode 186 may be arranged on the capacitor dielectric layer 184.

The peripheral circuit transistor PTR may be arranged on the second active region AC2 in the peripheral circuit region PCA. The peripheral circuit transistor PTR may include a gate dielectric layer 118, a peripheral circuit gate stack PGS, and a gate capping pattern 142P that are sequentially stacked on the second active region AC2.

The gate dielectric layer 118 may be arranged on the top surface of the substrate 110. The gate dielectric layer 118 may include at least one selected from a silicon oxide layer, a silicon nitride layer, a silicon oxynitride layer, an oxide/nitride/oxide (ONO) layer, and a high-k dielectric layer having a higher dielectric constant than the silicon oxide layer. The gate capping pattern 142P may be arranged to cover a top surface of the peripheral circuit gate stack PGS. In embodiments, the gate capping pattern 142P may include a silicon nitride layer.

The peripheral circuit gate stack PGS may include a peripheral lower conductive layer 132P, a peripheral metal silicide layer 134P, and a peripheral metal line stack 136P.

The peripheral lower conductive layer 132P may be arranged on the gate dielectric layer 118 and may include Si, Ge, W, WN, Co, Ni, Al, Mo, Ru, Ti, TiN, Ta, TaN, or Cu, or a combination of two or more thereof. The peripheral metal silicide layer 134P may be arranged on a top surface of the peripheral lower conductive layer 132P. In some embodiments, the peripheral metal silicide layer 134P may include at least one of cobalt silicide, nickel silicide, and/or tungsten silicide. In some embodiments, optionally, at least one conductive barrier layer of Ti, TiN, and/or TaN may be further arranged on the peripheral metal silicide layer 134P.

The peripheral metal line stack 136P may include a first peripheral conductive layer 136AP, a first peripheral intermediate layer 138AP, and a second peripheral conductive layer 136BP that are sequentially arranged on the peripheral metal silicide layer 134P. For example, the peripheral metal line stack 136P may have a structure in which the first peripheral intermediate layer 138AP is sandwiched between the first peripheral conductive layer 136AP and the second peripheral conductive layer 136BP.

In some embodiments, the first peripheral conductive layer 136A may include a first metal material, and the first metal material may include any one of Ru, Mo, Ro, Ir, and/or an alloy thereof. In some embodiments, the first peripheral conductive layer 136AP may include Ru.

In some embodiments, the first peripheral intermediate layer 138AP may include graphene. In some embodiments, graphene constituting the first peripheral intermediate layer 138AP may include a plurality of grains having a two-dimensional structure. For example, each grain of the first peripheral intermediate layer 138AP may have a two-dimensional structure in which 1 to 15 layers of carbon two-dimensional sheets are stacked layer-by-layer. In some embodiments, the first peripheral intermediate layer 138AP may have a nanocrystalline structure and a plurality of grains may have a grain size of about 2 nm to about 200 nm. In some embodiments, the first peripheral intermediate layer 138AP may have an average grain size of 10 nm or more.

In some embodiments, in terms of bonding energy of carbon atoms included in graphene, the first peripheral intermediate layer 138AP may include graphene including carbon atoms having sp² bonding in a ratio of 50% or more and 99% or less of all carbon atoms. The binding energy of the carbon atoms included in the first peripheral intermediate layer 138AP may be measured by using an analysis device such as XPS.

In some embodiments, the first peripheral intermediate layer 138AP may exhibit a D peak, a 2D peak, a D' peak, and a G peak of carbon atoms when measured by Raman spectroscopy, and a ratio of the D peak to the G peak of carbon atoms may be 3.0 or less, a ratio of the 2D peak to the G peak may be 0.1 or more, and a ratio of a D' peak to the G peak may be 1.0 or less. Here, the G peak may correspond to a Raman shift value of about 1,580 cm⁻¹, the D peak may correspond to a Raman shift value of about 1,350 cm⁻¹, and the 2D peak may correspond to a Raman shift value of about 2,700 cm⁻¹.

In some embodiments, the second peripheral conductive layer 136BP may include a first metal material, and the first metal material may include any one of Ru, Mo, Ro, Ir, an/ord an alloy thereof. In some embodiments, the second peripheral conductive layer 136BP may include Ru.

In some embodiments, the peripheral metal line stack 136P may have a first thickness t20 in the vertical direction Z. The first peripheral conductive layer 136AP may have a second thickness t21 in the vertical direction Z, the first peripheral intermediate layer 138AP may have a third thickness t22 in the vertical direction Z, and the second peripheral conductive layer 136BP may have a fourth thickness t23 in the vertical direction Z. The second thickness t21 of the first peripheral conductive layer 136AP may correspond to about 20 % to about 80 % of the first thickness t20 of the peripheral metal line stack 136P in the vertical direction Z. The fourth thickness t23 of the second peripheral conductive layer 136BP may correspond to about 20 % to about 80 % of the first thickness t20 of the peripheral metal line stack 136P in the vertical direction Z.

The third thickness t22 of the first peripheral intermediate layer 138AP may correspond to about 5% to about 50% of the first thickness t20 of the peripheral metal line stack 136P in the vertical direction Z. For example, when the third thickness t22 of the first peripheral intermediate layer 138AP is less than 5% of the first thickness t20, the first peripheral intermediate layer 138AP may not be thick enough to perform a grain agglomeration suppression function, and when the third thickness t22 of the first peripheral intermediate layer 138AP is greater than 50% of the first thickness t20, resistivity of the entirety of the peripheral metal line stack 136P may increase so that electrical performance of the semiconductor device 100 may deteriorate. In some embodiments, the third thickness t22 of the first peripheral intermediate layer 138AP may be 5 nm or less. In some embodiments, the third thickness t22 of the first peripheral intermediate layer 138AP may be 0.5 nm or more.

In some embodiments, constituent materials of the peripheral lower conductive layer 132P, the peripheral metal silicide layer 134P, the first peripheral conductive layer 136AP, the first peripheral intermediate layer 138AP, and the second peripheral conductive layer 136BP may be the same as those of the lower conductive layer 132, the metal silicide layer 134, the first conductive layer 136A, the first intermediate layer 138A, and the second conductive layer 136B included in the bit line BL in the cell array region MCA. For example, the peripheral circuit gate stack PGS may be simultaneously formed in a process of forming the bit line BL. However, the present disclosure is not limited thereto.

Both sidewalls of the peripheral circuit gate stack PGS and the gate capping pattern 142P may be covered with an insulating spacer 150P. The insulating spacer 150P may include an oxide layer or a nitride layer, or a combination thereof. The peripheral circuit transistor PTR and the insulating spacer 150P may be covered with a protective layer 144P, and a first interlayer insulating layer 148 may be arranged on the protective layer 144P and may fill a space between two adjacent peripheral circuit transistors PTR. A capping insulating layer 146P may be arranged on the first interlayer insulating layer 148 and the protective layer 144P.

A contact plug PCT may be formed in a contact hole PCTH that passes or extends through the first interlayer insulating layer 148 and the capping insulating layer 146P in the vertical direction in the peripheral circuit region PCA. The contact plug PCT may include a conductive barrier layer and a landing pad conductive layer in the same manner as the plurality of landing pads LP formed in the cell array region MCA. A metal silicide layer (not shown) may be between the second active region AC2 and the contact plug PCT. An upper interlayer insulating layer 190 may cover the contact plug PCT and may be arranged on the capping insulating layer 146P.

In general, as the line width of each of the plurality of bit lines BL decreases, resistance of the bit line BL increases. Therefore, technology is being attempted to employ a metal material with low resistivity, such as Ru, as the bit line BL. However, when the metal material such as Ru is patterned to have a relatively small line width, grain agglomeration or grain merging may occur in a subsequent high-temperature process, resulting in a significant increase in roughness of a metal material layer and a local line width increase region, a line width decrease region, and/or a line disconnected region.

However, according to some embodiments, the metal line stack 136 may include the first intermediate layer 138A between the first conductive layer 136A and the second conductive layer 136B and including graphene, and the first intermediate layer 138A may prevent the grain agglomeration of the metal material in the first conductive layer 136A and the second conductive layer 136B. Accordingly, the bit line BL may have relatively low resistance while preventing or reducing the occurrence of the local line width increase region, the line width decrease region, and/or the line disconnected region in the bit line BL during the formation process of the semiconductor device 100. Therefore, the semiconductor device 100 may have relatively high electrical characteristics.

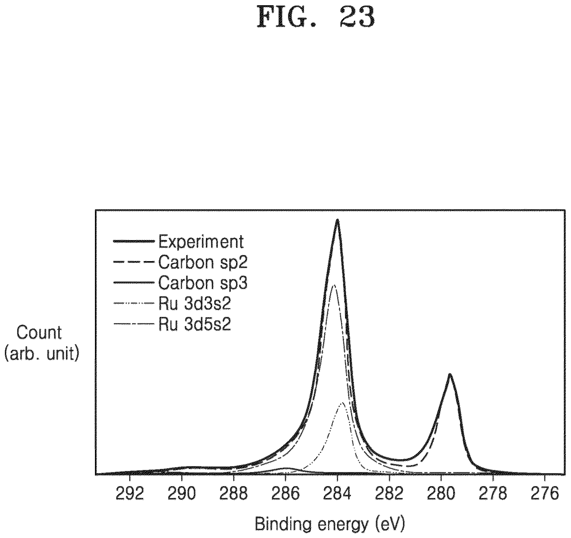

Hereinafter, crystallinity and physical characteristics of the metal line stack 136 included in the bit line BL will be described in greater detail with reference to FIGS. 23 to 26.

FIG. 23 is a graph illustrating XPS measurement results of a metal line stack according to some embodiments.

Referring to FIG. 23, the metal line stack according to some embodiments may have a stacked structure of a first conductive layer made of a first metal material, a first intermediate layer made of graphene, and a second conductive layer made of a first metal material. In the metal line stack according to some embodiments, the first intermediate layer may be formed to have a thickness corresponding to about 10% of the total thickness of the metal line stack. In FIG. 23, the first conductive layer may be formed by using Ru as the first metal material, an intermediate structure in which the first intermediate layer is formed by using graphene may be formed on the first conductive layer, and binding energy of carbon atoms and Ru metal atoms is measured with respect to the intermediate structure through XPS. As illustrated in FIG. 23, it may be noted that a sp² peak of carbon atoms is measured at a relatively high intensity in XPS measurement, and it may be confirmed that a graphene layer is formed in a layered structure on a metal material layer such as Ru.

Although FIG. 23 illustrates as an example the binding energy of the first intermediate layer including graphene using the XPS, in addition to the XPS, analysis devices such as transmission electron microscopy (TEM), energy dispersive X-ray spectroscopy (EDX), and electron energy loss spectroscopy (EELS) may enable atomic binding energy analysis of a structure in which the first intermediate layer is between the first and second conductive layers.

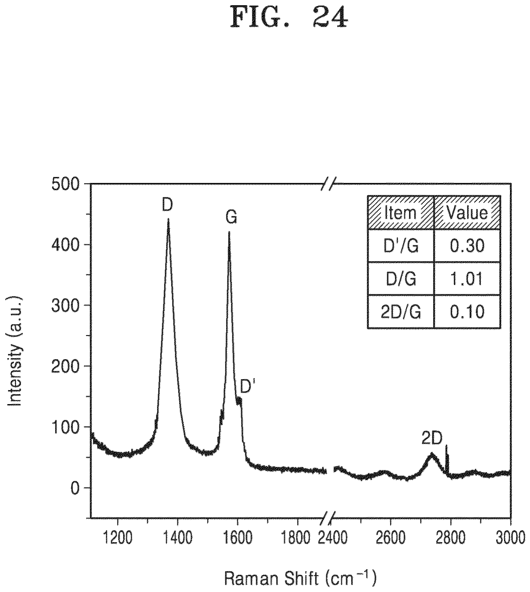

FIG. 24 is a graph illustrating a Raman spectrum of a metal line stack according to some embodiments.

In FIG. 24, the first conductive layer may be formed by using Ru the first metal material, an intermediate structure in which the first intermediate layer is formed by using graphene may be formed on the first conductive layer, and a Raman spectrum of graphene may be measured for the intermediate structure through Raman spectroscopy.

Graphene may exhibit a D peak, a 2D peak, a D' peak, and a G peak of carbon atoms, the G peak may correspond to a Raman shift value of about 1,580 cm⁻¹, the D peak may correspond to a Raman shift value of about 1,350 cm⁻¹, and the 2D peak may correspond to a Raman shift value of about 2,700 cm⁻¹. The ratio of the D peak to the G peak of carbon atoms may be 1.01 (i.e., D/G = 1.01), the ratio of the 2D peak to the G peak may be 0.10 (i.e., 2D/G = 0.10), and the ratio of the D' peak to the G peak may be 0.30 (i.e., D'/G = 0.30). From the Raman spectrum illustrated in FIG. 24, it may be confirmed that graphene is formed in a layered nanocrystalline structure having relatively high crystallinity.

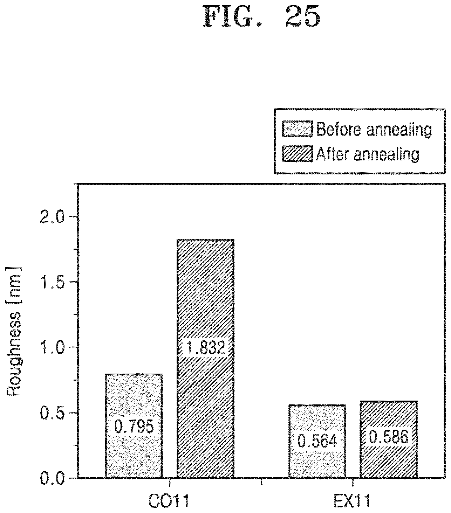

FIG. 25 is a graph illustrating a change in roughness of a metal line CO11 according to a comparative example and a metal line stack EX11 according to an embodiment of the present inventive concepts before and after annealing.

Referring to FIG. 25, the metal line CO 11 according to the comparative example may have a single layer structure formed of a first metal material, and the metal line stack EX11 according to the embodiment of the present inventive concepts may have a stacked structure of a first conductive layer formed of a first metal material, a first intermediate layer formed of graphene, and a second conductive layer formed of a first metal material. In the metal line stack EX11 according to the embodiment of the present inventive concepts, the first intermediate layer may be formed to have a thickness corresponding to about 10% of the total thickness of the metal line stack EX11, and the total thickness of the metal line CO11 according to the comparative example may be the same as the total thickness of the metal line stack EX11 according to the embodiment of the present inventive concepts. In addition, annealing treatment may be performed on the metal line CO11 according to the comparative example and the metal line stack EX11 according to the embodiment of the present inventive concepts for several minutes at a temperature of about 600 °C, and surface root mean square (RMS) roughness may be measured by atomic force microscopy before and after annealing treatment, respectively.

The metal line CO11 according to comparative example has an average roughness of 0.795 nm before the annealing treatment, but has an average roughness of 1.832 nm after the annealing treatment. The average roughness of the metal line CO11 according to the comparative example increased by about 130 % after the annealing treatment when compared to the initial value before the annealing treatment, which may be assumed to be because grains of the first metal material are exposed to a high temperature during the annealing treatment, resulting in grain aggregation or agglomeration, and thus changing surface morphology to a roughened surface.

The metal line stack EX11 according to the embodiment of the present inventive concepts has an average roughness of 0.564 nm before the annealing treatment, but has an average roughness of 0.586 nm after the annealing treatment. The average roughness of the metal line stack EX11 according to the embodiment of the present inventive concepts does not increase or slightly increases after the annealing treatment when compared to the initial value before the annealing treatment. It may be confirmed that the metal line stack EX11 according to the embodiment of the present inventive concepts shows relatively little change in surface morphology even after the annealing treatment. It may be assumed that, although the grains of the first metal material are exposed to a high temperature during the annealing treatment, the grains of the first metal material included in the first conductive layer and the second conductive layer do not undergo grain aggregation or agglomeration due to the presence of the first intermediate layer including graphene that is sandwiched between the first conductive layer and the second conductive layer.

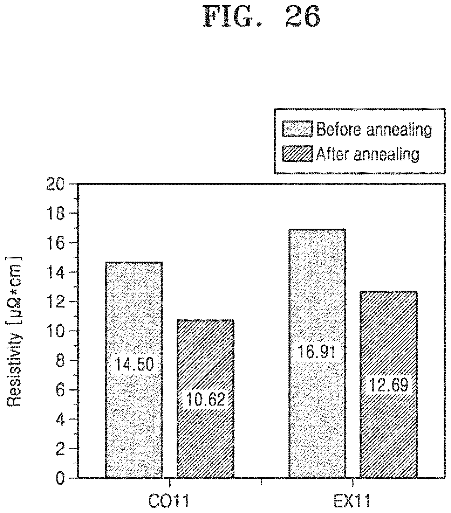

FIG. 26 is a graph illustrating a change in resistivity of a metal line CO11 according to a comparative example and a metal line stack EX11 according to an embodiment of the present inventive concepts before and after annealing.

Referring to FIG. 26, the metal line CO 11 according to the comparative example has resistivity of 14.50 µΩ·cm before the annealing treatment, but has resistivity of 10.62 µΩ·cm after the annealing treatment. The resistivity of the metal line CO11 according to the comparative example decreases by about 26.8% of initial resistivity after the annealing treatment, when compared to the initial value before the annealing treatment.

The metal line stack EX11 according to the embodiment of the present inventive concepts has resistivity of 16.91 µΩ·cm before the annealing treatment, but has resistivity of 12.69 µΩ·cm after the annealing treatment. The resistivity of the metal line stack EX11 according to the embodiment of the present inventive concepts decreases by about 25.0% of initial resistivity after the annealing treatment, when compared to the initial value before the annealing treatment. Although the metal line stack EX11 according to the embodiment of the present inventive concepts has a slightly higher resistivity value than the metal line CO11 according to the comparative example, it may be confirmed that the metal line stack EX11 has a similar value to the metal line CO11 according to the comparative example in a resistivity reduction rate after annealing treatment.

Referring to FIGS. 25 and 26 together, while the metal line CO11 according to the comparative example has a roughened surface morphology after the annealing treatment, the metal line stack EX11 according to the embodiment of the present inventive concepts maintains an initial surface morphology almost the same after the annealing treatment. In addition, the resistivity of the metal line stack EX11 according to the embodiment of the present inventive concepts decreases to a similar extent to that of the metal line CO11 according to the comparative example after the annealing treatment. Accordingly, the bit line BL including the metal line stack EX11 according to the embodiment of the present inventive concepts has relatively low resistance while preventing or reducing occurrence of the local line width increase region, the line width decrease region, and/or the line disconnected region in the bit line BL due to the high-temperature process.

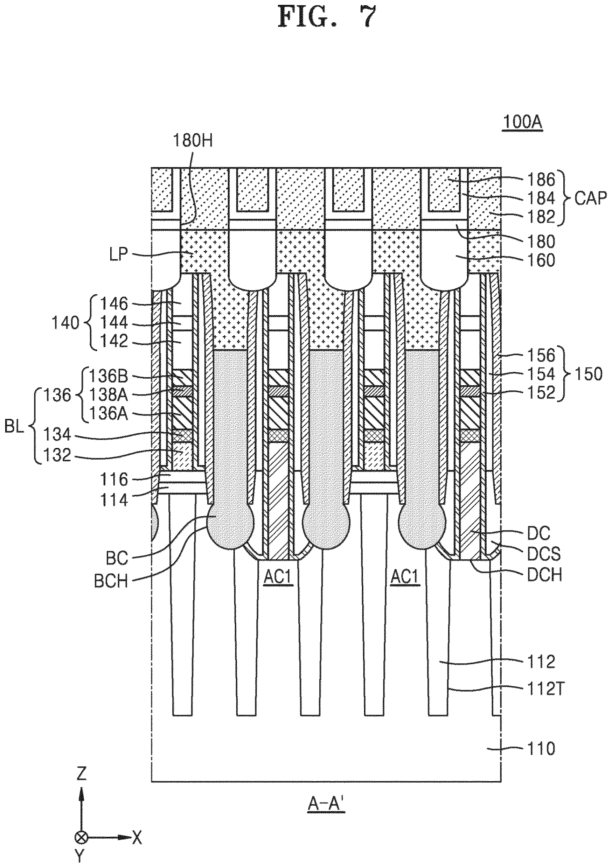

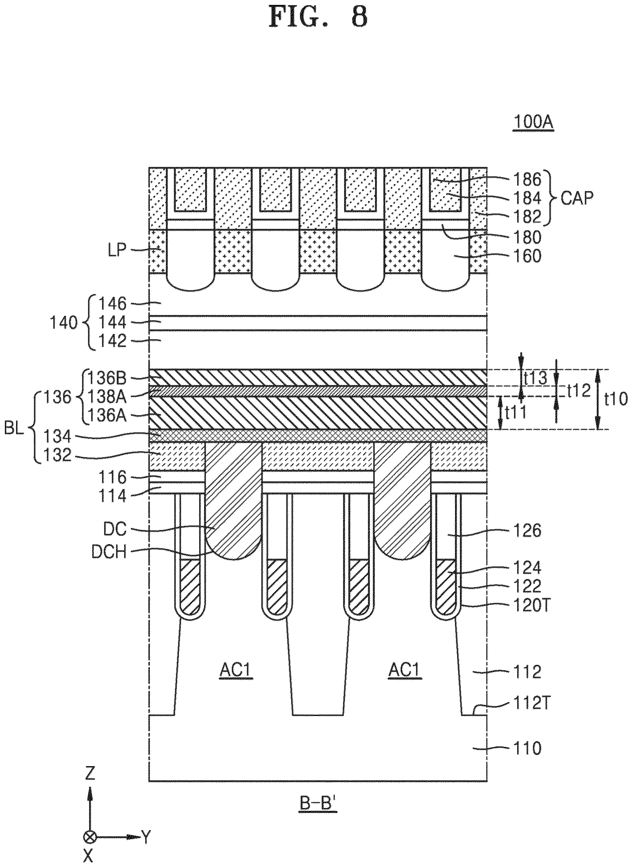

FIGS. 7 and 8 are cross-sectional views illustrating a semiconductor device 100A according to some embodiments.

Referring to FIGS. 7 and 8, a metal line stack 136 may include a first conductive layer 136A, a first intermediate layer 138A, and a second conductive layer 136B, and a second thickness t11 of the first conductive layer 136A in the vertical direction Z may be greater than a fourth thickness t13 of the second conductive layer 136B in the vertical direction Z.

In some embodiments, the second thickness t11 of the first conductive layer 136A may correspond to about 40% to about 80% of a first thickness t10 of the metal line stack 136 in the vertical direction Z. The fourth thickness t13 of the second conductive layer 136B may correspond to about 10% to about 30% of the first thickness t10 of the metal line stack 136 in the vertical direction Z. A third thickness t12 of the first intermediate layer 138A may correspond to about 5% to about 20% of the first thickness t10 of the metal line stack 136 in the vertical direction Z.

The embodiments described with reference to FIGS. 7 and 8 are not mutually exclusive to the embodiments described with reference to FIGS. 1 to 6, and it will be understood that the thickness of each of the first conductive layer 136A, the first intermediate layer 138A, and the second conductive layer 136B in the embodiments described with reference to FIGS. 7 and 8 may partially overlap the thickness of each of the first conductive layer 136A, the first intermediate layer 138A, and the second conductive layer 136B in the embodiments described with reference to FIGS. 1 to 6.

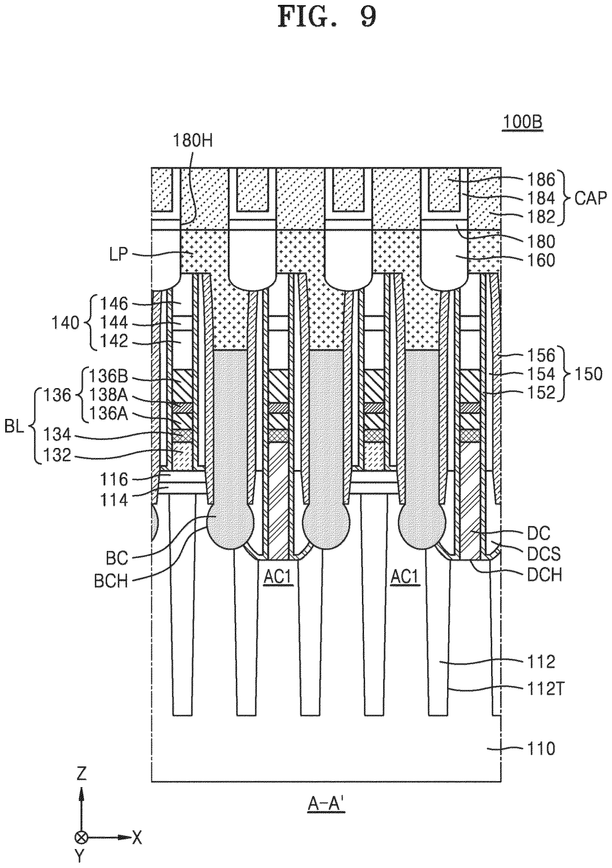

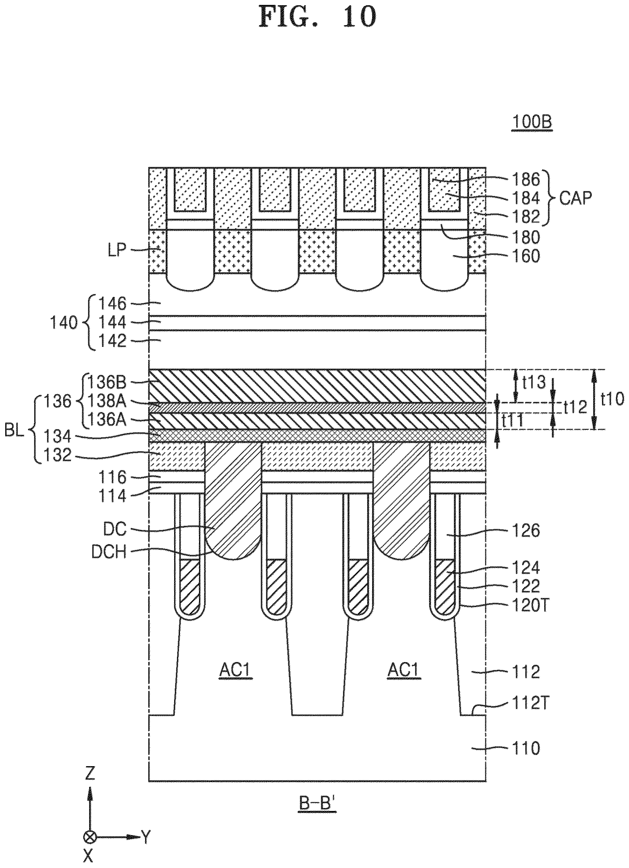

FIGS. 9 and 10 are cross-sectional views illustrating a semiconductor device 100B according to some embodiments.

Referring to FIGS. 9 and 10, a metal line stack 136 may include a first conductive layer 136A, a first intermediate layer 138A, and a second conductive layer 136B, and a second thickness t11 of the first conductive layer 136A in the vertical direction Z may be less than a fourth thickness t13 of the second conductive layer 136B in the vertical direction Z.

In some embodiments, the second thickness t11 of the first conductive layer 136A may correspond to about 10% to about 30% of a first thickness t10 of the metal line stack 136 in the vertical direction Z. The fourth thickness t13 of the second conductive layer 136B may correspond to about 40% to about 80% of the first thickness t10 of the metal line stack 136 in the vertical direction Z. A third thickness t12 of the first intermediate layer 138A may correspond to about 5% to about 20% of the first thickness t10 of the metal line stack 136 in the vertical direction Z.

The embodiments described with reference to FIGS. 9 and 10 are not mutually exclusive to the embodiments described with reference to FIGS. 1 to 6, and it will be understood that the thickness of each of the first conductive layer 136A, the first intermediate layer 138A, and the second conductive layer 136B in the embodiments described with reference to FIGS. 9 and 10 may partially overlap the thickness of each of the first conductive layer 136A, the first intermediate layer 138A, and the second conductive layer 136B in the embodiments described with reference to FIGS. 1 to 6.

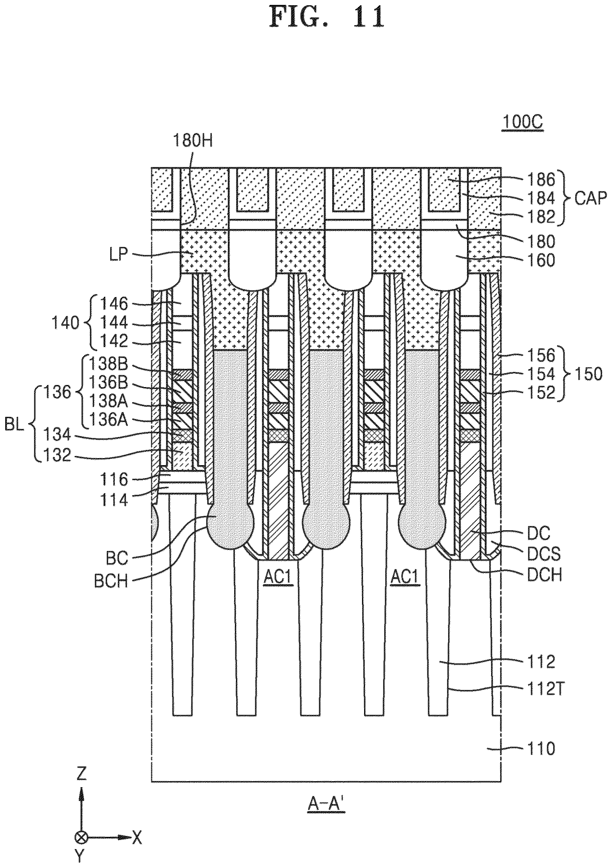

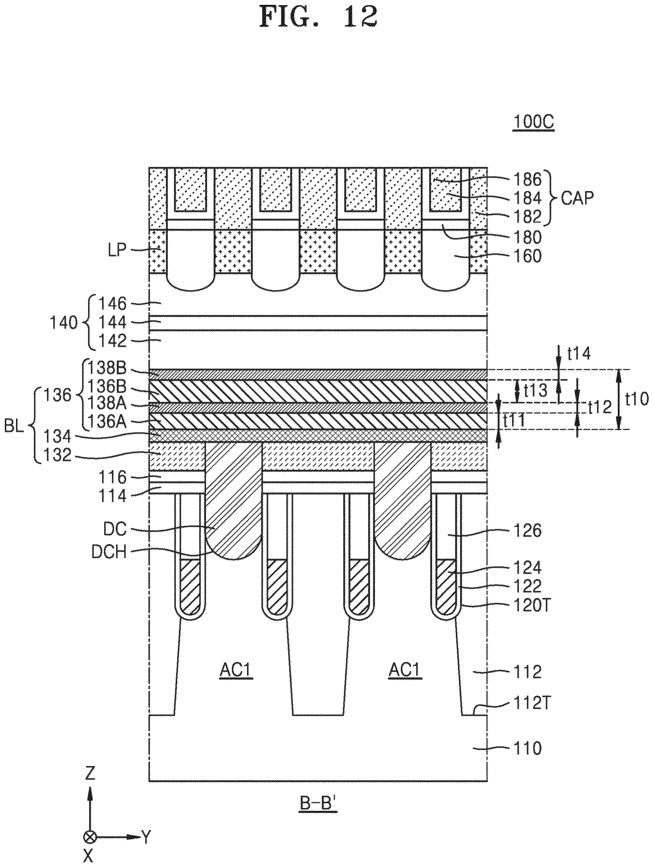

FIGS. 11 and 12 are cross-sectional views illustrating a semiconductor device 100C according to some embodiments.

Referring to FIGS. 11 and 12, a metal line stack 136 may include a first conductive layer 136A, a first intermediate layer 138A, a second conductive layer 136B, and a second intermediate layer 138B that are sequentially arranged on a metal silicide layer 134. The second intermediate layer 138B may include graphene, and for example, graphene constituting the second intermediate layer 138B may include a plurality of grains having a two-dimensional structure.

In some embodiments, the metal line stack 136 may have a first thickness t10 in the vertical direction Z, the first conductive layer 136A may have a second thickness t11 in the vertical direction Z, the first intermediate layer 138A may have a third thickness t12 in the vertical direction Z, the second conductive layer 136B may have a fourth thickness t13 in the vertical direction Z, and the second intermediate layer 138B may have a fifth thickness 114 in the vertical direction Z. The second thickness 111 of the first conductive layer 136A may correspond to about 20% to about 60% of the first thickness t10 of the metal line stack 136 in the vertical direction Z. The fourth thickness t13 of the second conductive layer 136B may correspond to about 20% to about 60% of the first thickness t10 of the metal line stack 136 in the vertical direction Z. The third thickness t12 of the first intermediate layer 138A may correspond to about 5% to about 30% of the first thickness t10 of the metal line stack 136 in the vertical direction Z. The fifth thickness 114 of the second intermediate layer 138B may correspond to about 5% to about 30% of the first thickness t10 of the metal line stack 136 in the vertical direction Z.

The metal line stack 136 consisting of four layers of the first conductive layer 136A, the first intermediate layer 138A, the second conductive layer 136B, and the second intermediate layer 138B is illustrated in FIGS. 11 and 12. However, in some embodiments, the metal line stack 136 may further include an additional conductive layer including a first metal material and an additional intermediate layer including graphene.

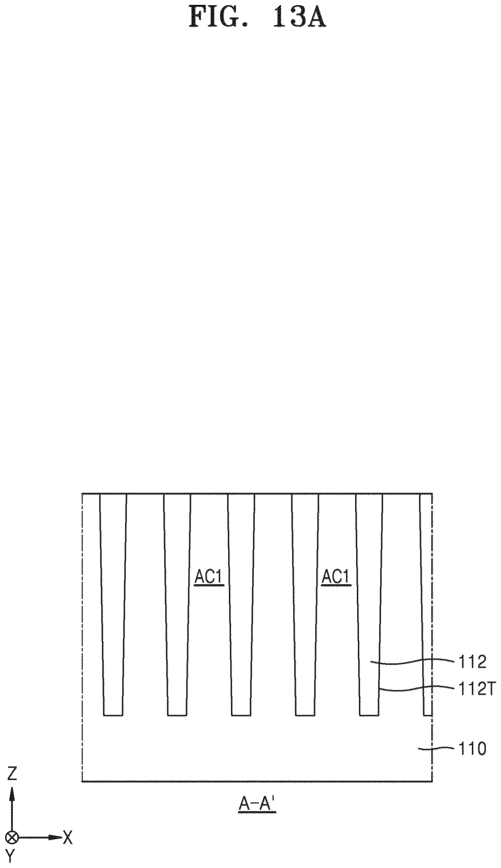

FIGS. 13A, 13B, 14A, 14B, 15A, 15B, 16A, 16B, 17A, 17B, 18A, 18B, 19A, 19B, 20A, 20B, 21A, 21B, 22A, and 22B are cross-sectional views illustrating a method of manufacturing the semiconductor device 100 according to some embodiments. Specifically, FIGS. 13A, 14A, 15A, 16A, 17A, 18A, 19A, 20A, 21A, and 22A are cross-sectional views taken along the line A-A' of FIG. 2, and FIGS. 13B, 14B, 15B, 16B, 17B, 18B, 19B, 20B, 21B, and 22B are cross-sectional views taken along the line B-B' of FIG. 2.

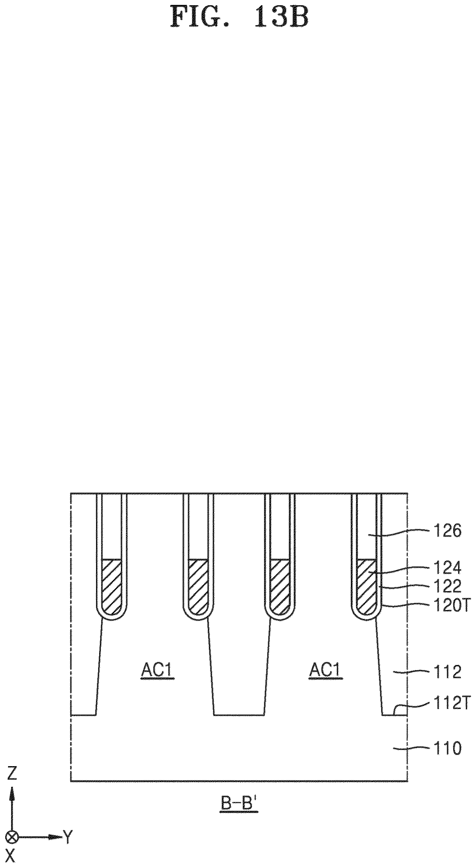

Referring to FIGS. 13A and 13B, the plurality of device isolation trenches 112T may be formed in the substrate 110.

Then, the plurality of first device isolation layers 112 filling the plurality of device isolation trenches 112T may be formed. The plurality of first active regions AC1 may be defined in the substrate 110 by forming the plurality of first device isolation layers 112. In a plan view, the plurality of first active regions AC1 may extend in a first diagonal direction D1 (refer to FIG. 2) inclined at a predetermined angle with the first horizontal direction X and the second horizontal direction Y.

In some embodiments, the plurality of first device isolation layers 112 may include silicon oxide, silicon nitride, or silicon oxynitride, or a combination of two or more thereof. In some examples, the first device isolation layer 112 may have a double-layer structure of a silicon oxide layer and a silicon nitride layer. However, the present disclosure is not limited thereto.

A mask pattern (not shown) may be formed on the substrate 110, and a part of the substrate 110 may be removed by using the mask pattern as an etching mask to form the word line trench 120T. For example, the mask pattern for forming the word line trench 120T may be formed by using a double patterning technique (DPT) or a quadruple patterning technique (QPT). However, the present disclosure is not limited thereto.

Then, the gate dielectric layer 122, the gate electrode 124, and the word line capping layer 126 may be sequentially formed in the word line trench 120T.

For example, the gate dielectric layer 122 may be arranged on and may conform to an internal wall of the word line trench 120T. The gate electrode 124 may be formed by filling the word line trench 120T with a conductive layer (not shown), and then etching back an upper portion of the conductive layer to expose a part of an upper side of the word line trench 120T again. The word line capping layer 126 may be formed in the exposed part of the word line trench 120T.

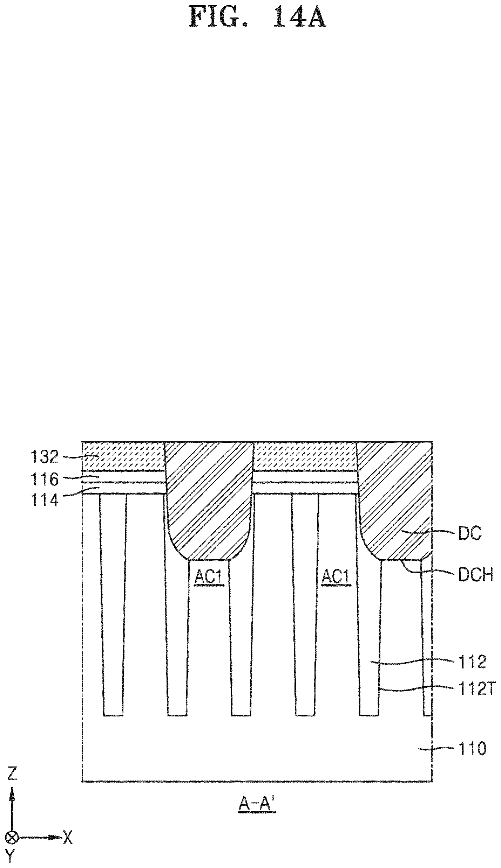

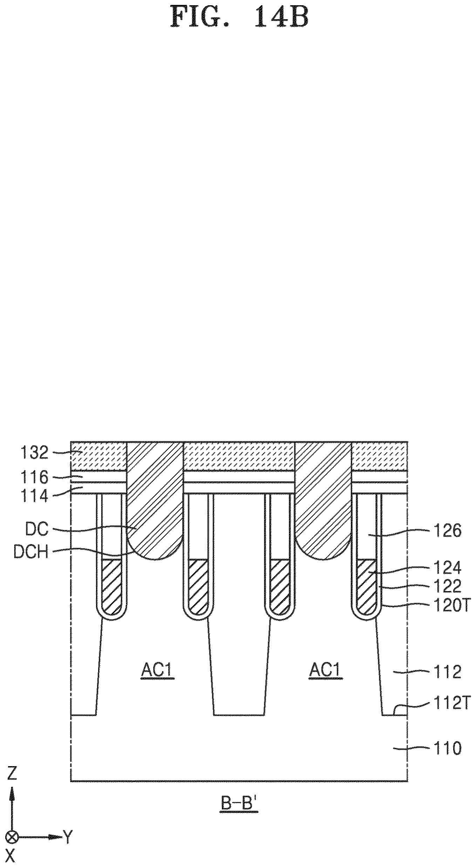

Referring to FIGS. 14A and 14B, a first buffer insulating layer 114 and a second buffer insulating layer 116 may be formed on the first active region AC1 and the first device isolation layer 112. Then, the lower conductive layer 132 may be formed on the first and second buffer insulating layers 114 and 116. Parts of the lower conductive layer 132, the first and second buffer insulating layers 114 and 116, and the substrate 110 may be removed to form the bit line contact hole DCH. Then, the bit line contact DC may be formed of a conductive material in the bit line contact hole DCH.

In some embodiments, the lower conductive layer 132 may include Si, Ge, W, WN, Co, Ni, Al, Mo, Ru, Ti, TiN, Ta, TaN, or Cu, or a combination of two or more thereof. In some embodiments, the bit line contact DC may include TiN, TiSiN, W, tungsten silicide, or doped polysilicon, or a combination of two or more thereof.

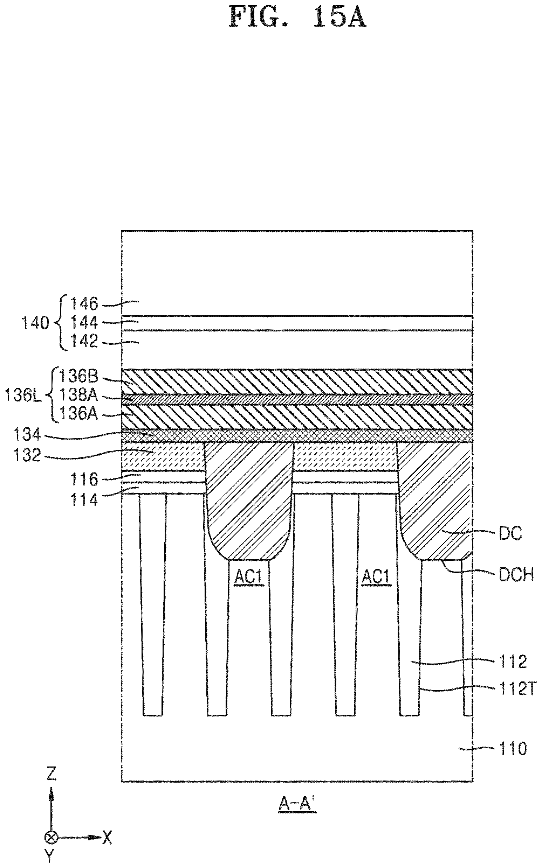

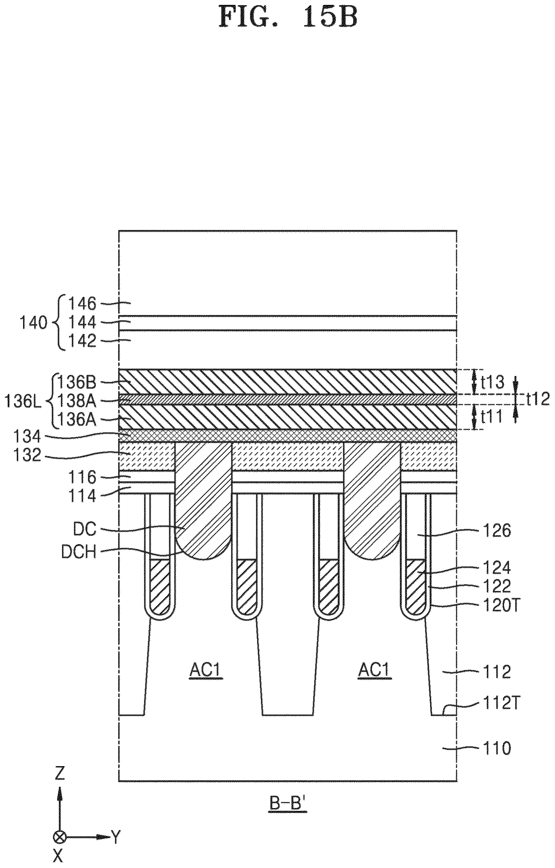

Referring to FIGS. 15A and 15B, the metal silicide layer 134 may be formed on the bit line contact DC and the lower conductive layer 132. The metal silicide layer 134 may include at least one of cobalt silicide, nickel silicide, and/or tungsten silicide. Optionally, a conductive barrier layer may be further formed on the metal silicide layer 134 by using at least one of Ti, TiN, and TaN.

Then, the first conductive layer 136A, the first intermediate layer 138A, and the second conductive layer 136B may be sequentially formed on the metal silicide layer 134.

In some embodiments, the first conductive layer 136A may include a first metal material, and the first metal material may include any one of Ru, Mo, Ro, Ir, and/or an alloy thereof. The first conductive layer 136A may be formed by using at least one of a physical vapor deposition (PVD) process, a chemical vapor deposition (CVD) process, and/or an atomic layer deposition (ALD) process.

The first intermediate layer 138A may include graphene and may be formed, for example, by using at least one of a CVD process using plasma, a thermal CVD process, and/or an ALD process. For example, the CVD process using plasma may include at least one of microwave plasma CVD, inductively coupled plasma (ICP) CVD, capacitively coupled plasma (CCP) CVD, or pulsed plasma CVD.

In some embodiments, the second conductive layer 136B may include a first metal material, and the first metal material may include any one of Ru, Mo, Ro, Ir, and/or an alloy thereof. The first conductive layer 136A may be formed by using at least one of the PVD process, the CVD process, and/or the ALD process.

Here, a stacked structure of the first conductive layer 136A, the first intermediate layer 138A, and the second conductive layer 136B may be referred to as a metal line stack layer 136L. Then, the bit line capping layer 140 may be formed on the metal line stack layer 136L. The bit line capping layer 140 may include the first capping layer 142, the second capping layer 144, and the third capping layer 146 that may be sequentially arranged on a top surface of the metal line stack layer 136L. The first capping layer 142, the second capping layer 144, and the third capping layer 146 may include at least one of silicon nitride, silicon oxide, and/or silicon oxynitride.

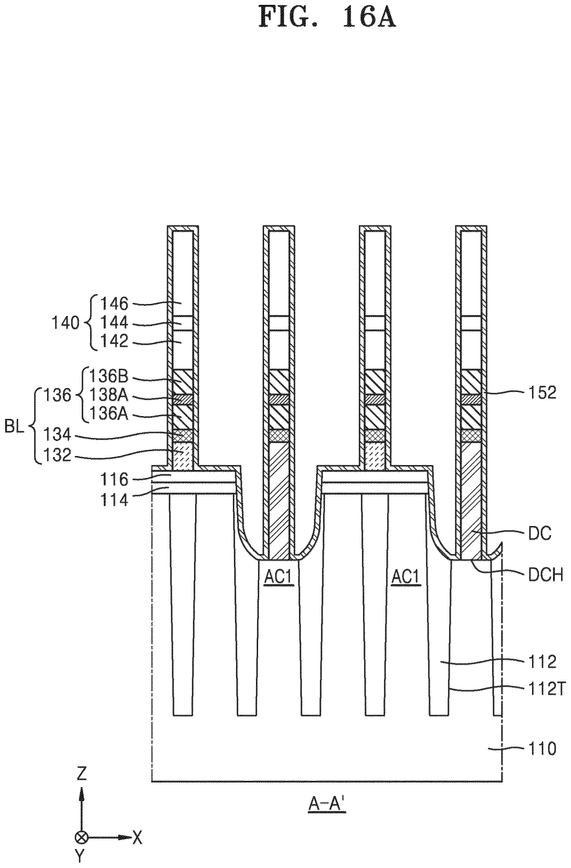

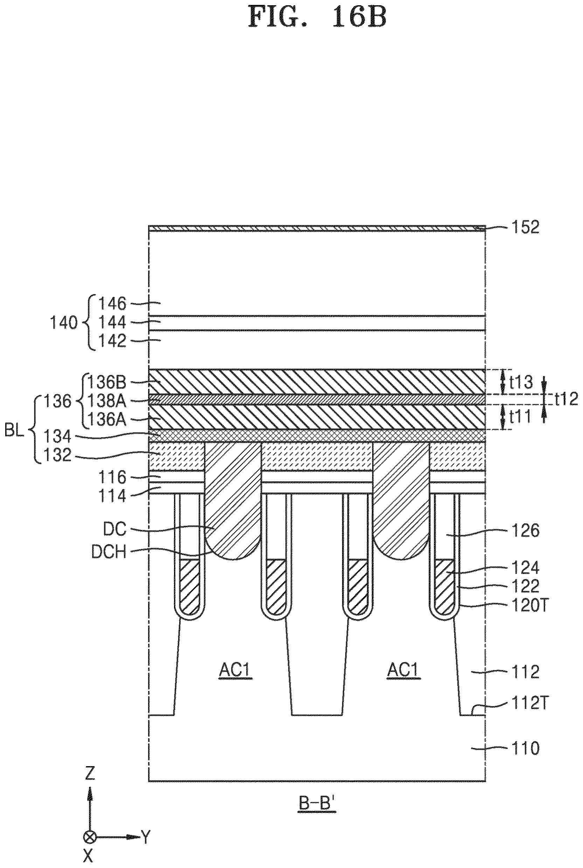

Referring to FIGS. 16A and 16B, the plurality of bit lines BL may be formed by patterning the metal line stack layer 136L, the metal silicide layer 134, and the lower conductive layer 132 by using the bit line capping layer 140 as an etching mask.

In the patterning process for forming the plurality of bit lines BL, a part of the bit line contact DC arranged in the bit line contact hole DCH may also be removed. Accordingly, as illustrated in FIG. 16A, the sidewalls of the bit line contact DC may be aligned with the sidewalls of the bit line BL, and an internal wall of the bit line contact hole DCH may be exposed again on both sides of the bit line contact DC.

Then, the first spacer layer 152 may be formed on the sidewalls of the bit line BL, the bit line capping layer 140, and the bit line contact DC. The first spacer layer 152 may also be arranged on and may conform to the internal wall of the bit line contact hole DCH. In some embodiments, the first spacer layer 152 may include silicon nitride.

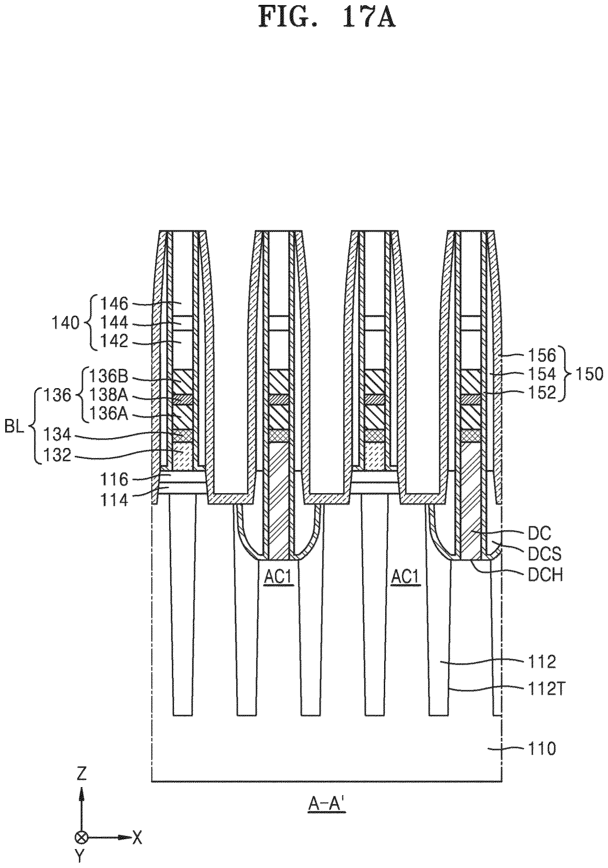

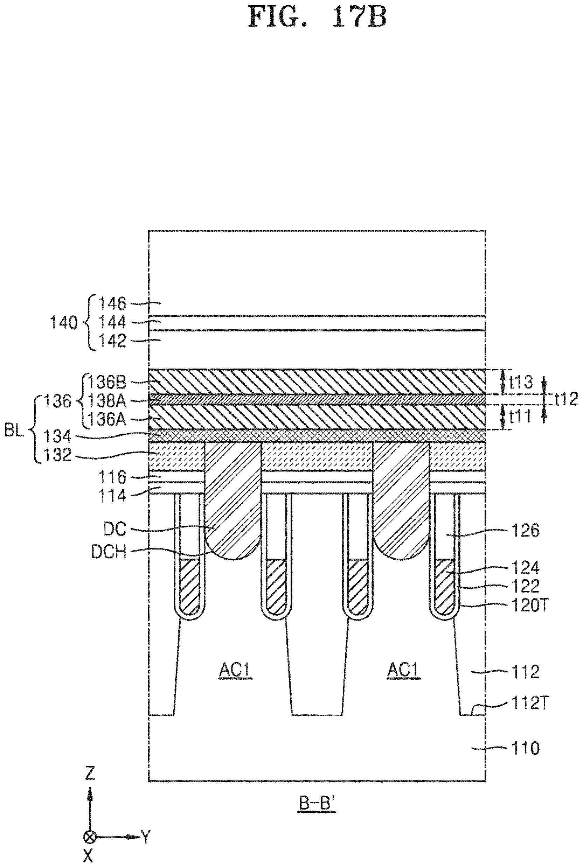

Referring to FIGS. 17A and 17B, the bit line contact spacer DCS may be formed by filling the remaining part of the bit line contact hole DCH on the first spacer layer 152. For example, the bit line contact spacer DCS may include silicon nitride or silicon oxide.

Then, the second spacer layer 154 may be formed on the sidewalls of the bit line BL and the bit line capping layer 140. In some embodiments, the second spacer layer 154 may include silicon oxide.

Then, an anisotropic etching process may be performed on the second spacer layer 154 and the first and second buffer insulating layers 114 and 116 arranged between the bit lines BL may be removed to expose the top surface of the substrate 110.

Thereafter, the third spacer layer 156 may be formed on and may conform to the second spacer layer 154 and the top surface of the substrate 110. In some embodiments, the third spacer layer 156 may include silicon nitride.

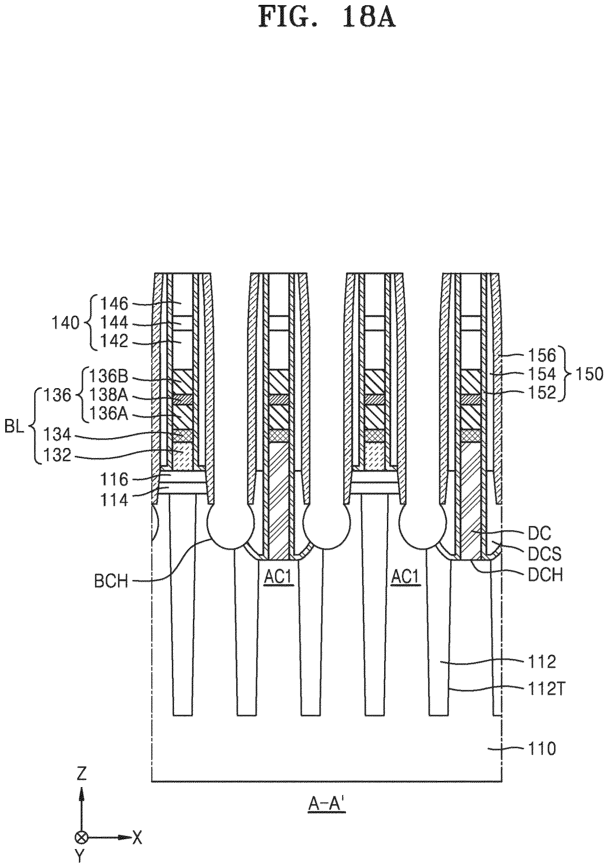

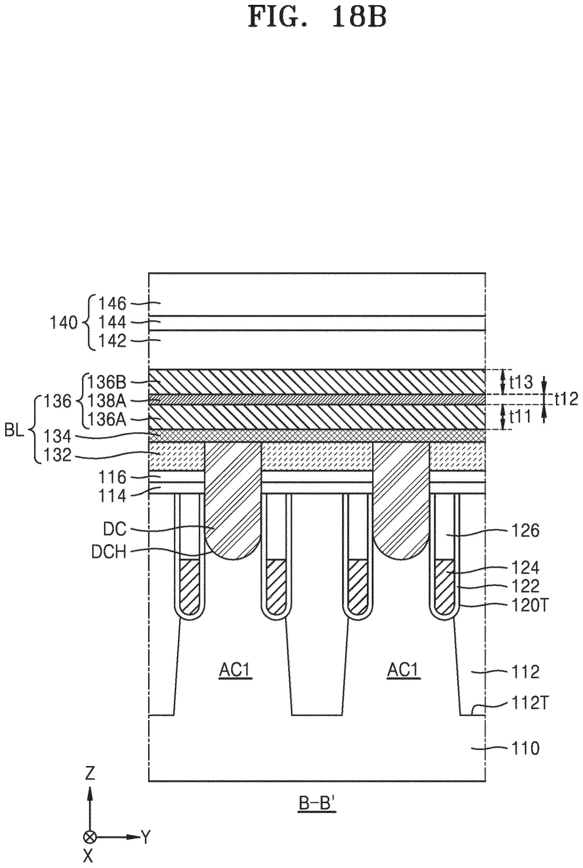

Referring to FIGS. 18A and 18B, the buried contact holes BCH may be formed by further removing upper sides of the substrate 110 exposed to spaces among the plurality of bit lines BL. In some embodiments, the process of forming the buried contact holes BCH may include a wet etching process or a dry etching process, or a combination thereof.

In the etching process for forming the buried contact holes BCH, a part of an upper side of the bit line capping layer 140 may also be removed so that a top surface level of the bit line capping layer 140 may be lowered.

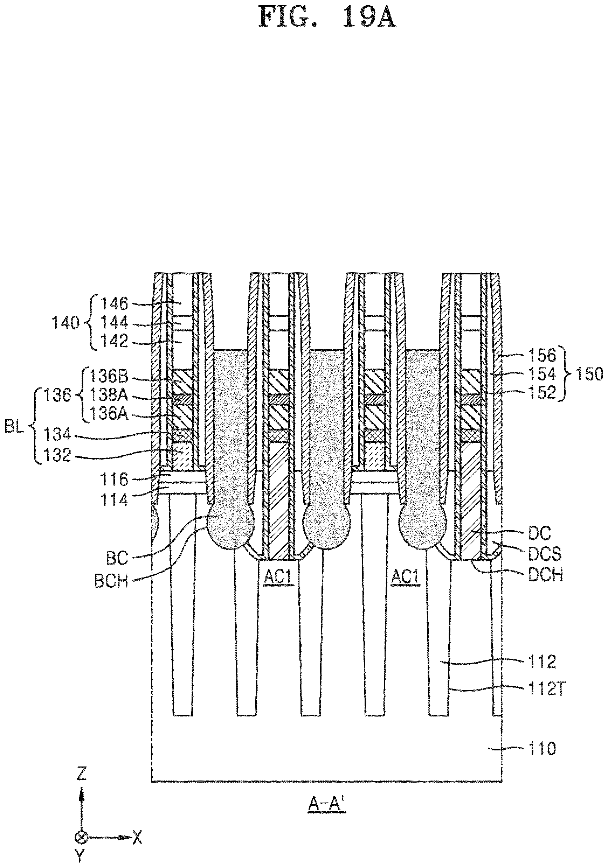

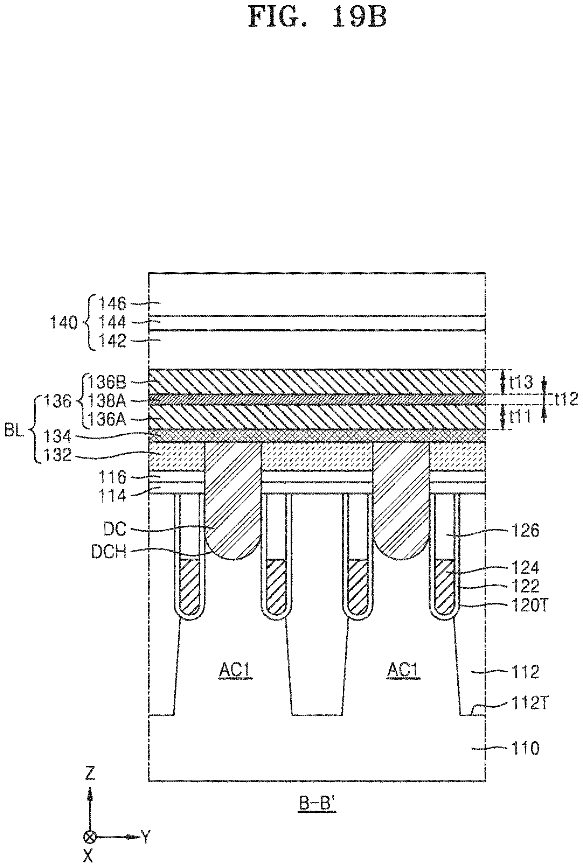

Referring to FIGS. 19A and 19B, the buried contacts BC filling the buried contact holes BCH may be formed. In some embodiments, the buried contacts BC may include doped polysilicon.

In some embodiments, the buried contact hole BCH is formed to have a line-type planar shape arranged between adjacent bit lines BL, and then a preliminary contact layer having a line-type planar shape may be formed in the buried contact hole BCH, and the preliminary contact layer may be patterned to form the buried contact BC. Then, an insulating fence may be formed by using an insulating material in the space between the buried contacts BC (for example, a space from which a part of the preliminary contact layer is removed).

In other embodiments, before forming the buried contact hole BCH, a plurality of insulating fences may be formed by using an insulating material at an intersection of two adjacent bit lines (BL) BL and word line trenches 120T, the buried contact hole BCH may be formed by removing a part of the substrate (110) 110 arranged between the plurality of bit lines (BL) BL and between the plurality of insulating fences, and then the buried contact BC may be formed in the buried contact hole BCH.

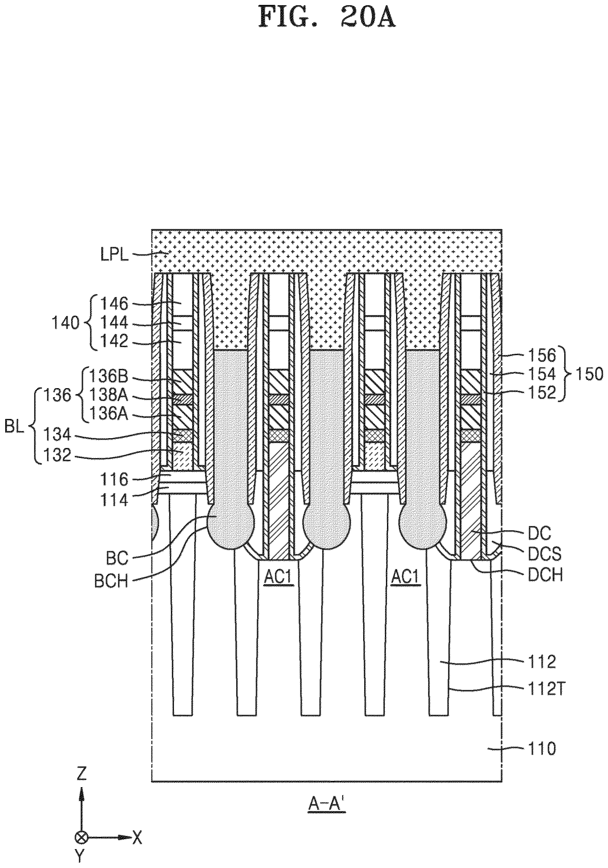

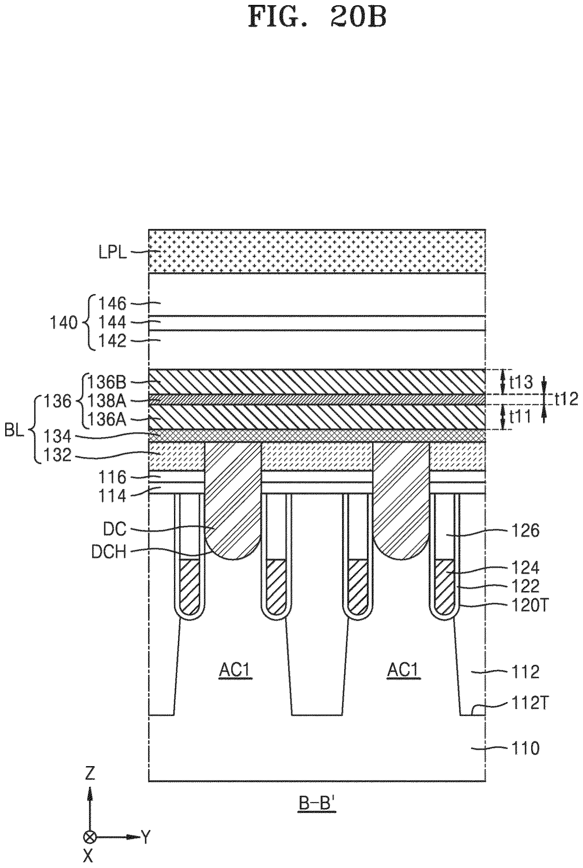

Referring to FIGS. 20A and 20B, a landing pad conductive layer LPL may be formed on top surfaces of the plurality of buried contacts BC. The landing pad conductive layer LPL may be formed to have a sufficient thickness to contact the plurality of buried contacts BC and to cover the top surfaces of the plurality of bit line (BL) capping layers 140.

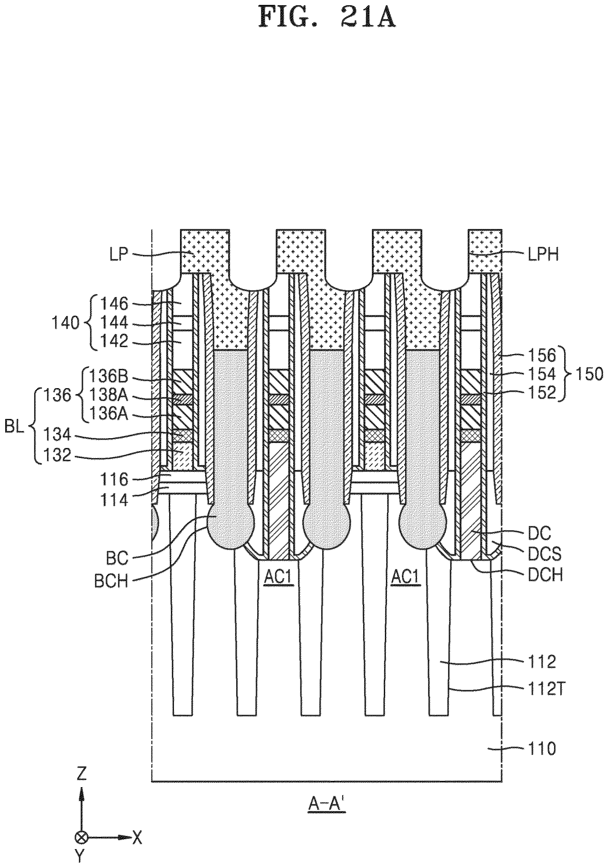

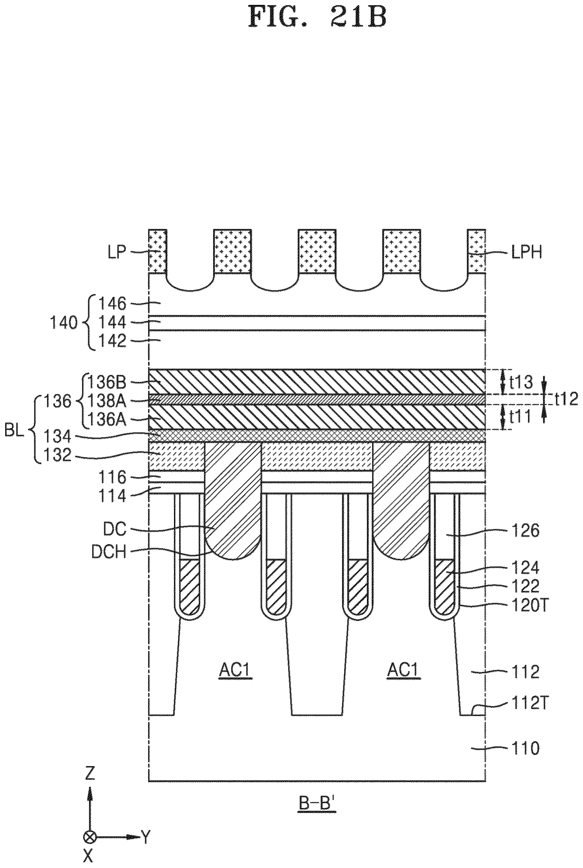

Referring to FIGS. 21A and 21B, a mask pattern may be formed on the landing pad conductive layer LPL, and the landing pad conductive layer LPL may be patterned by using the mask pattern as an etching mask to form landing pad openings LPH. The plurality of landing pads LP arranged on the plurality of buried contacts BC may be formed by the landing pad openings LPH.

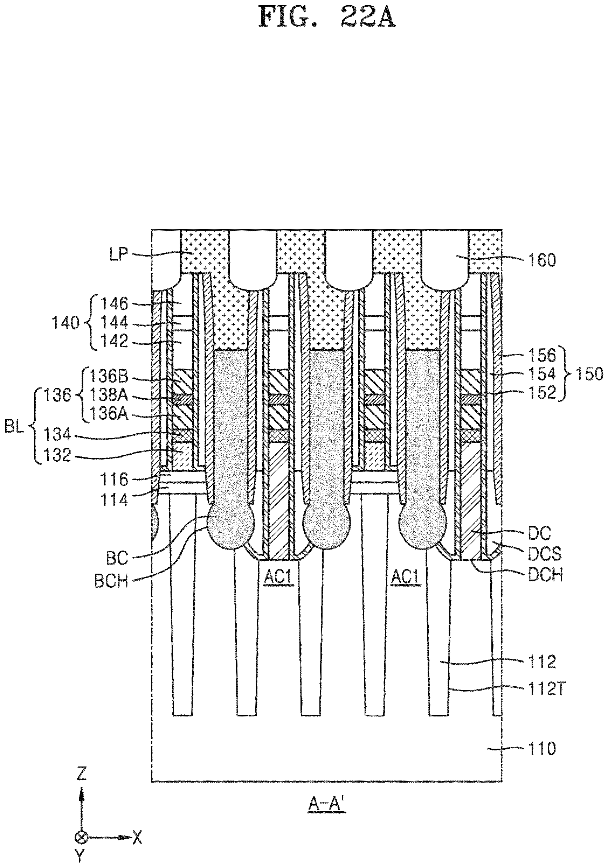

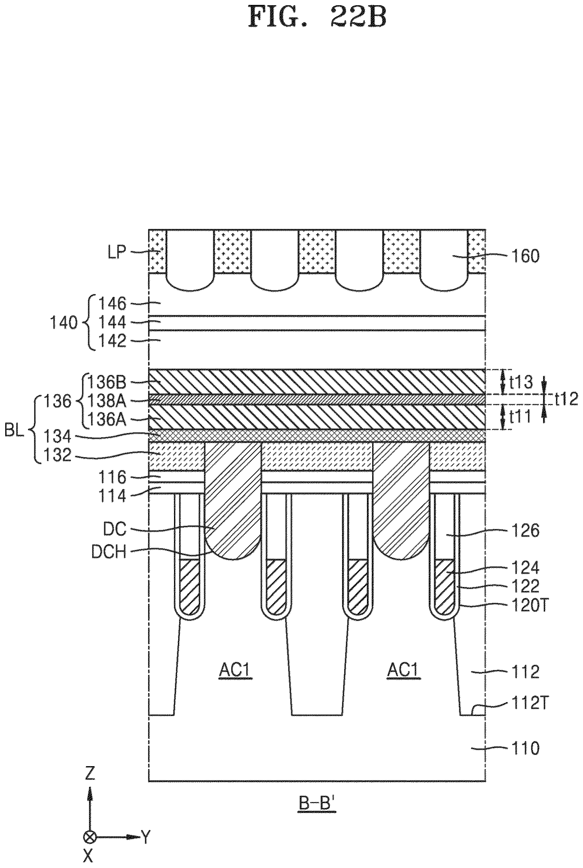

Referring to FIGS. 22A and 22B, the insulating patterns 160 may be formed in the landing pad openings LPH by using an insulating material. The insulating patterns 160 may be arranged to cover sidewalls of the plurality of landing pads LP.

Referring back to FIGS. 3 and 4, the plurality of lower electrodes 182 connected to the plurality of landing pads LP may be formed, and the capacitor dielectric layers 184 and the upper electrodes 186 may be sequentially formed on sidewalls of the plurality of lower electrodes 182.

The semiconductor device 100 may be formed by performing the above-described method, with the understanding that the present disclosure is not limited thereto.

According to some embodiments, the bit line may include a metal line stack, and the metal line stack may have a structure in which a first conductive layer including a first metal material such as Ru, a first intermediate layer including graphene, and a second conductive layer including the first metal material are sequentially stacked. The first intermediate layer may suppress and prevent grain agglomeration and/or grain overgrowth of the first conductive layer and the second conductive layer in a heat treatment during manufacturing processes, thereby preventing local disconnection of the bit line.

## Claims

1. A semiconductor device (100, 100A-C) comprising:
a substrate (110) including a first active region (AC1) defined by a first device isolation layer (112);
a bit line contact (DC) arranged on the first active region (AC1) of the substrate (110); and
a bit line (BL) that extends in a first direction (Y) on the substrate (110), wherein the bit line (BL) comprises:
a lower conductive layer (132) arranged on the substrate (110) and on a sidewall of the bit line contact (DC); and
a metal line stack (136) arranged on the lower conductive layer (132), and
wherein the metal line stack (136) comprises:
a first conductive layer (136A) arranged on the lower conductive layer (132) and the bit line contact (DC) and including a first metal material;
a first intermediate layer (138A) arranged on the first conductive layer (136A) and including graphene; and
a second conductive layer (136B) arranged on the first intermediate layer (138A) and including the first metal material.

2. The semiconductor device (100, 100A-C) of claim 1, wherein the metal line stack (136) has a first thickness (t10) in a vertical direction (Z), wherein the first intermediate layer (138A) has a second thickness (t12) in the vertical direction (Z), and
wherein the second thickness (t12) is in a range of about 5% to 50% of the first thickness (t10).

3. The semiconductor device (100, 100A-C) of claim 2, wherein the second thickness (t12) of the first intermediate layer (138A) is in a range of about 0.5 nm to 5 nm.

4. The semiconductor device (100, 100A-C) of any one of claims 1 to 3,
wherein the first metal material comprises at least one of ruthenium (Ru), molybdenum (Mo), rhodium (Ro), or iridium (Ir), or an alloy of one or more thereof.

5. The semiconductor device (100, 100A-C) of any one of claims 1 to 4,
wherein the first metal material comprises ruthenium (Ru).

6. The semiconductor device (100, 100A-C) of any one of claims 1 to 5,
wherein the first intermediate layer (138A) comprises 50% to 99% of carbon atoms with sp² bonds as analyzed by X-ray photoelectron spectroscopy.

7. The semiconductor device (100, 100A-C) of any one of claims 1 to 6, wherein, as analyzed by Raman spectroscopy, the first intermediate layer (138A) has a ratio of a D peak to a G peak of carbon atoms of 3.0 or less, a ratio of a 2D peak to the G peak of 0.1 or more, and a ratio of a D' peak to the G peak of 1.0 or less.

8. The semiconductor device (100, 100A-C) of any one of claims 1 to 7, further comprising a bit line spacer (150) arranged on sidewalls of the bit line (BL), wherein the bit line spacer (150) contacts sidewalls of the lower conductive layer (132) and sidewalls of the metal line stack (136).

9. The semiconductor device (100, 100A-C) of claim 8, wherein sidewalls of the first intermediate layer (138A) contact the bit line spacer (150).

10. The semiconductor device (100, 100A-C) of any one of claims 1 to 9,
wherein the bit line (BL) further comprises a metal silicide layer (134, 134P) arranged on the lower conductive layer (132) and on the metal line stack (136).

11. The semiconductor device (100, 100A-C) of claim 10, wherein the metal silicide layer (134, 134P) is between the lower conductive layer (132) and the first conductive layer (136A) and between the bit line contact (DC) and the first conductive layer (136A).

12. The semiconductor device (100, 100A-C) of any one of claims 1 to 11,
wherein the metal line stack (136) further comprises a second intermediate layer (138B) that is arranged on the second conductive layer (136B) and that includes graphene.

13. The semiconductor device (100, 100A-C) of any one of claims 1 to 12,
wherein the substrate (110) further comprises a second active region (AC2) defined by a second device isolation layer (112P), wherein the semiconductor device (100, 100A-C) further comprises a peripheral circuit gate stack (PGS) arranged on the second active region (AC2), wherein the peripheral circuit gate stack (PGS) comprises:
a peripheral lower conductive layer (132P); and
a peripheral metal line stack (136P) that is arranged on the peripheral lower conductive layer (132P), and
wherein the peripheral metal line stack (136P) comprises:
a first peripheral conductive layer (136AP) that is arranged on the peripheral lower conductive layer (132P) and that includes the first metal material;
a first peripheral intermediate layer (138AP) that is arranged on the first peripheral conductive layer (136AP) and that includes graphene; and
a second peripheral conductive layer (136BP) that is arranged on the first peripheral intermediate layer (138AP) and that includes the first metal material.

14. The semiconductor device (100, 100A-C) of claim 13, wherein the peripheral metal line stack (136P) has a third thickness (t20) in a vertical direction (Z), wherein the first peripheral intermediate layer (138AP) has a fourth thickness (t22) in the vertical direction (Z), and
wherein the fourth thickness (t22) is in a range of about 5% to 50% of the third thickness (t20).

15. The semiconductor device (100, 100A-C) of claim 14, wherein the fourth thickness (t22) of the first peripheral intermediate layer (138AP) is in a range of about 0.5 nm to 5 nm.
